# EUROPEAN PATENT APPLICATION

(11) **EP 1 833 286 A1**
(43) Date of publication of application: **12.09.2007**
(21) Application number: 05822355.3
(22) Date of filing: 27.12.2005
(51) Int. Cl.: H05K 3/46

(54) **WIRING BOARD AND WIRING BOARD MANUFACTURING METHOD**

(30) Priority: 28.12.2004 JP 2004381462; 21.01.2005 JP 2005014388; 16.02.2005 JP 2005039763; 23.02.2005 JP 2005046734
(71) Applicant: NGK Spark Plug Co., Ltd., Nagoya-shi, Aichi 467-8525 (JP)
(72) Inventor: Yuri, Shinji c/o Ngk Spark Plug Co., Ltd., Nagoya-shi, Aichi; 4678525 (JP); Origuchi, Makoto c/o Ngk Spark Plug Co., Ltd., Nagoya-shi, Aichi; 4678525 (JP); Inui, Yasuhiko c/o Ngk Spark Plug Co., Ltd., Nagoya-shi, Aichi; 4678525 (JP); Otsuka, Jun c/o Ngk Spark Plug Co., Ltd., Nagoya-shi, Aichi; 4678525 (JP)
(74) Representative: Grünecker, Kinkeldey, Stockmair & Schwanhäusser Anwaltssozietät
(86) International application number: PCT/JP2005/023909
(87) International publication number: WO 2006/070807

(57) **Abstract**

A wiring board 1 is formed with a stacked wiring layer portion 6 in which a dielectric layer and a conductor layer are stacked on at least one main surface of a core board portion 2, the stacked wiring layer portion 6 including a stacked composite layer portion 8 in which a polymer dielectric layer 3A, a conductor layer 4B and a ceramic dielectric layer 5 are stacked in this order. The conductor layer 4B in the stacked composite layer portion 8 is partially cut in the in-plane direction so as to be formed with a conductor side cut portion 18, and the ceramic dielectric layer 5 is partially cut in the in-plane direction so as to have a ceramic side cut portion 16, and the ceramic side cut portion 16 and the conductor side cut portion 18 are communicated to form a communication cut portion 21. Polymer constituting the polymer dielectric layer 3A is filled in the communication cut portion 21 so as to extend through the conductor side cut portion 18 to the ceramic side cut portion 16.

## Description

### TECHNICAL FIELD

The present invention relates to a wiring board and a wiring board manufacturing method.

### BACKGROUND TECHNIQUE

Patent Document 1: Unexamined Japanese Patent Publication No. 2003-142624

Since in an integrated circuit device such as CPU and other LSI that operates at high speed, power source wires branching off from a common power source are allotted to a plurality of circuit blocks within an integrated circuit, there is a problem that when a number of elements within the circuit blocks perform high-speed switching at the same time, large current is drawn from the power source at one time and a resulting variation in the power source voltage will become a kind of noise, which noise is transmitted to the respective circuit blocks through the power source wires. Thus, from a point of view of inhibiting transmission of noise between the blocks due to the power source variation, it is effective to provide each circuit block with a decupling capacitor for lowering a power source impedance.

In the meantime, in case of a large-scale integrated circuit such as CPU, the number of circuit blocks formed therein is large and there is a tendency that the number of power source terminals and ground terminals increases, so that the distance between the terminals is decreasing more and more. A decupling capacitor needs to be connected to each power source wire extending toward each circuit block, so that it is not only difficult from a point of view of a mounting technology but it goes against a miniaturizing trend or the like to connect capacitors separately to an integrated circuit having a number of densely arranged terminals.

Thus, in the patent document 1, it is disclosed a decupling capacitor having stacked strong dielectric and metallic layers and formed with a number of capacitor terminals to be connected separately to densely arranged integrated circuit side terminals. Since in a high frequency range (particularly, in a frequency range equal to or higher than 100 MHz) wherein a noise problem due to power source voltage variation at high-speed switching is liable to become noticeable, the relative importance of the inductive reactance term in the source impedance becomes large, it is effective for decrease of the source impedance, to dispose a source terminal and a ground terminal as close as possible. Further, there is such a problem that the inductance of a terminal portion, when increased, is combined with a capacity component of a decoupling capacitor to cause a resonance point, thus making smaller the band width where a sufficient impedance reduction effect is obtained. Accordingly, it has an advantage of contributing to reduction in the source impedance and increase in the band for such reduction, which is a primary object, as well as to simply making the element small-sized, to make a capacitor that is smaller in the distance between terminals as described above.

However, in the above-described patent document 1, there is provided a structure in which a capacitor is installed on an intermediate board interposed between an electronic part and a wiring board, thus causing a problem that the working time necessitated for installation of the electronic part on the wiring board is increased for the interposition of the intermediate board and it becomes difficult to make the assembly of the wiring board and the electronic part be lower in height. The inventors investigated installation of a capacitor in which high dielectric ceramic layers are used, in a so-called organic wiring board in which a build-up layer made of polymer is used as a dielectric layer, through replacement with part of the above-described build-up layer. This makes it possible to realize decrease in the height of the assembly but the following problem arises.
Namely, the adhering strength between the build-up layer and the capacitor portion is liable to decrease, particularly when a thermal cycle such as a reflow process for flip-chip connection of an electronic part is applied to the build-up layer and the capacitor portion, the thermal shear stress level between the layers due to the difference in the line expansion coefficient between the build-up layer and the high inductive ceramic layer becomes higher, thus being liable to cause a problem of peeling or the like. Further, the capacitor using a thin layer of high inductive ceramic is difficult in handing at the time of connection to the build-up layer for wiring, thus causing a problem of a low manufacturing efficiency.

Further, by the prior technology, there is caused the following problems since the capacity to be formed is increased by forming the capacitor at an area that is determined as wide as possible with respect to the size of the external shape of a single unit (package) of wiring board but the capacitor portions are cut at the time of dicing if the single unit of wiring board and the capacitor have the same size.
(1) If an electrode made of metal such as Cu is exposed at an end surface of a package after dicing, oxidation-corrosion of the electrode is caused.
(2) The adherence at the interface between an electrode and a ceramic dielectric layer is weaker as compared with that between polymeric materials, thus possibly causing interlayer peeling due to shearing stress at the time of dicing and an intrusion path for intake of moisture thereafter.
(3) Sagging of an electrode made of metal such as Cu is liable to occur at the time of dicing, and shortage occurs between the layers.
(4) As compared with a single polymeric substance, an electrode made of metal such as Cu, particularly a ceramic dielectric layer made of high dielectric such as titanic acid barium increases the load at the time of dicing and accelerates wear and chipping of a blade.

Further, the inventors examined, in a wiring board, e.g., an organic wiring board, using a build-up resin insulation layer made of a polymeric material as a dielectric layer, installation of a capacitor using a high dielectric ceramic layer through replacement with part of the above-described build-up resin insulation layer. This enables to realize a smaller height of the assembly as compared with the structure using an intermediate board.

While it is considered to form capacitors on both of a first side (front side) and a second side (rear side) of a core board portion, a capacitor should be formed only on the first side on which electronic parts are mounted for suppressing increase in the cost if a sufficient capacity is attained on one side only. In case such a structure is employed, the following problems arise.

One problem is that treatment liquid used for forming a capacitor on the first side causes an influence on elements on the second side. Particularly, desmear treatment liquid used for removing residue at via holes causes a problem since it corrodes a polymeric material. In a usual manufacturing process for an organic wiring board, the build-up processes are advanced concurrently at both sides of the core board portion, so that there is not caused such a problem that larger corrosion is caused on one side. However, such a theory cannot be used in case a capacitor having a ceramic dielectric layer is formed only on one side of a core board portion. When a conductive layer constituting an electrode on an upper side of a capacitor is formed, a via is formed for connecting the conductive layer to a core board portion side conductive layer of the same polarity. A via hole for constituting the via is formed and a via conductor is formed on an inner surface of the via hole, which via hole is necessarily washed before formed with the conductor. When the via hole is washed, a polymer dielectric layer exposed at the second side is subjected to an unnecessary corroding action by washing liquid. For this reason, there is caused an inequality in the surface condition between a polymer dielectric layer to be newly formed on the first side after the capacitor is formed and a polymer dielectric layer on the second side. This fact means that it is difficult to form plating layers of a uniform thickness and a uniform quality on the first and second sides.

Another problem is that the first and second sides become unequal in the mechanical characteristics depending upon whether they are formed with a capacitor. This fact means that a defect such as bending or peeling is liable to be caused after a thermal history.

### SUMMARY OF THE INVENTION

An object of the present invention is to provide a wiring board manufacturing method capable of manufacturing a wiring board having a structure in which a ceramic dielectric layer and a polymer dielectric layer are composite laminated, with ease, and a wiring board manufactured by that method and capable of increasing the adhering strength between layers while being hard to cause a problem such as peeling at the time of reflow process or the like.

Another object of the present invention is to provide a wiring board which is structured to be able to prevent, in a wiring board having a built-in capacitor, the capacitor from being exposed at the end surface of the package and be hard to cause shortage between layers while being high in the reliability by making an external end surface of a ceramic dielectric layer constituting a capacitor withdraw from an end surface of a package and by making an external end surface of an electrode of the capacitor further withdraw from the external end surface of the ceramic dielectric layer.

To accomplish the above-described objects, there is provided according to a first aspect of the present invention a method of manufacturing a wiring board including a stacked wiring layer portion in which a dielectric layer and a conductor layer are stacked is formed on at least one main surface of a core board portion, the stacked wiring layer portion including a stacked composite layer portion in which a polymer dielectric layer, a conductor layer and a ceramic dielectric layer are stacked in this order from a core board portion side so as to contact with each other, characterized by executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly by forming the polymer dielectric layer on a main surface of the core board portion, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

By the above-described wiring board manufacturing method, in case of manufacturing a wiring board in which a stacked wiring layer portion including a dielectric layer and a conductor layer is formed on at least one main surface of a core board portion, which stacked wiring layer portion includes a stacked composite layer portion in which a polymer dielectric layer (so-called build-up layer), a conductor layer and a ceramic dielectric layer are stacked in this order from a core board portion side so as to contact with each other, a first stacked layer assembly is manufactured by forming the ceramic dielectric layer and the conductor layer in this order on one main surface of a transfer base plate, the first stacked layer assembly is stacked on the second stacked layer assembly which is manufactured by forming the polymer dielectric layer on the main surface of the core board portion so as to allow them to stick together, and thereafter the transfer base plate is removed. Namely, the ceramic dielectric layer that is thin and fragile can be supplied to the sticking step by being reinforced by the transfer base plate and needs not to be handled by itself, thus making it possible to make dramatically higher the manufacturing efficiency and the yield rate of the wiring board having the stacked composite layer portion in which the polymer dielectric layer, conductor layer and the ceramic dielectric layer are stacked as described above.

According to a second aspect of the present invention, there is provided a wiring board characterized in that a stacked wiring layer portion in which a dielectric layer and a conductor layer are stacked is formed on at least one main surface of a core board portion, the stacked wiring layer portion includes a stacked composite layer portion in which a polymer dielectric layer, a conductor layer and a ceramic dielectric layer are stacked in this order from a core board portion side so as to contact with each other, the conductor layer in the stacked composite layer portion is partially cut in the in-plane direction so as to have a conductor side cut portion, the ceramic dielectric layer is partially cut in the in-plane direction so as to have a ceramic side cut portion, the ceramic side cut portion and the conductor side cut portion are communicated to form a communication cut portion, and polymer constituting the polymer dielectric layer is filled in the communication cut portion so as to extend through the conductor side cut portion to the ceramic side cut portion.

With the structure of above-described the wiring board according to the present invention, it is adapted so that in a stacked composite layer portion in which a polymer dielectric layer, a conductor layer and a ceramic dielectric layer are stacked in this order from a core board portion side so as to contact with each other, the polymer constituting the polymer dielectric layer is filled in the communication cut portion formed in the conductor layer and the ceramic dielectric layer, and therefore by the anchor effect the adhering strength can be made higher and a problem of peeling or the like at the time of reflow process or the like can be made hard to be caused.

The above-describe wiring board can be manufactured as follows by using the manufacturing method of this invention. Namely, the first stacked layer assembly manufacturing step is executed in a way as to include a ceramic side cut portion patterning step of patterning the ceramic side cut portion in the ceramic dielectric layer formed on one main surface of the transfer base plate, a conductor layer forming step of forming a conductor layer on the ceramic dielectric layer after the patterning, and a conductor side cut portion patterning step of patterning the conductor side cut portion in the conductor layer in a way as to communicate the conductor side cut portion with the ceramic side cut portion. In the sticking step, on the first stacked layer assembly which is formed with the communication cut portion including the ceramic side cut portion and the conductor side cut portion communicated therewith is stacked the second stacked layer assembly in a state in which the polymer dielectric layer is uncured or semi-cured in a way as to stack the main surface of the polymer dielectric layer on the main surface of the first stacked layer assembly on the side where the communication cut portion is open, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured. By this method, the uncured or semi-cured polymer constituting the polymer dielectric layer can be filled in the communication cut portion assuredly by sticking under pressure, and therefore the structure of the above-described wiring board can be obtained with ease.

Then, the wiring board of this invention includes, when the conductor layer included in the stacked composite layer portion is referred to as a first conductor layer, a second conductor layer stacked on the ceramic dielectric layer from the side opposite to the first conductor layer, and the first conductor layer, the ceramic dielectric layer and the second conductor layer can constitute a capacitor. By this structure, a capacitor for decoupling, etc. can be installed in the stacked wiring layer portion including the polymer dielectric layer (build-up layer), and attachment of an intermediate board having installed therein a capacitor between the wiring board and electronic components (not shown) can be made unnecessary, thus contributing the small height of the assembly. In this instance, it is desirable to form, after the transfer base plate removing step is finished, the second conductor layer on the main surface side of the ceramic dielectric layer, from which the transfer base plate is removed.

According to a third aspect of the present invention, there is provided a wiring board having a stacked composite layer portion in which a polymer dielectric layer, a conductor layer and a ceramic dielectric layer made of ceramic of a high dielectric constant are stacked in this order so as to contact with each other, characterized in that the conductor layer in the stacked composite layer portion is partially cut in the in-plane direction so as to have a conductor side cut portion, the ceramic dielectric layer is partially cut in the in-plane direction so as to have a ceramic side cut portion, the ceramic side cut portion and the conductor side cut portion being communicated to form a communication cut portion, a polymer constituting the polymer dielectric layer is filled in the communication cut portion so as to extend through the conductor side cut portion to the ceramic side cut portion, when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer is withdrawn from an end surface of a unit of the wiring board at least by a first withdrawal width, external end surfaces of the first conductor layer and the second conductor layer are withdrawn from the end surface of the unit of the wiring board at least by a second withdrawal width larger than the first withdrawal width, and a capacitor is constituted by the first conductor layer, the ceramic dielectric layer and the second conductor layer.

According to a fourth aspect of the present invention, there is provided a method of manufacturing a wiring board including a stacked composite layer portion in which a polymer dielectric layer, a conductor layer and a ceramic dielectric layer made of ceramic of a high dielectric constant are stacked in this order so as to contact with each other, characterized by executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly by forming the polymer dielectric layer on a main surface of a core board portion, a sticking step of sticking conductor layers of a plurality of the first stacked layer assemblies and the polymer dielectric layer of the second stacked layer assembly so that when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer is withdrawn from an end surface of a unit of the wiring board at least by a first withdrawal width, external end surfaces of the first conductor layer and the second conductor layer are withdrawn from the end surface of the unit of the wiring board at least by a second withdrawal width larger than the first withdrawal width, and a capacitor is constituted by the first conductor layer, the ceramic dielectric layer and the second conductor layer, and a transfer base plate removing step of removing the transfer base plate from the ceramic dielectric layer, in this order.

By the wiring board according to the third aspect of the present invention and the wiring board manufacturing method according to the fourth aspect of the present invention, since the external end surface of the ceramic dielectric layer is withdrawn from the end surface of the unit of the wiring board at least by the first withdrawal width and the external end surfaces of the first conductor layer and the second conductor layer are withdrawn from the end surface of the unit of the wiring board by the second withdrawal width larger than the first withdrawal width, and the capacitor is constituted by the first conductor layer, the ceramic dielectric layer and the second conductor layer, the following effects are obtained.
(1) Since the fist conductor layer, the ceramic dielectric layer and the second conductor layer are never exposed at an end surface of a package after dicing, oxidation corrosion at the package end surface can be prevented.
(2) Interlayer peeling and an intrusion path for intake of moisture due to shearing stress at the time of dicing can be prevented.
(3) Shortage between layers due to sagging of an electrode made of Cu or the like metal at the time of dicing can be prevented.
(4) The load at the time of dicing can be reduced by avoiding cutting of the electrode made of metal such as Cu and the ceramic dielectric layer made of strong dielectric such as titanic acid barium.

Further, while the wiring board to which the present invention is applied can be structured, for example, so as to be formed with a stacked wiring layer portion in which a dielectric layer and a conductor layer are stacked at least on one main surface of a board portion, the stacked wiring layer portion including a stacked composite layer portion in which a polymer dielectric layer (so-called build-up resinous insulation layer), a conductor layer and a ceramic dielectric layer are stacked in this order from the core board portion so as to contact with each other, it is a matter of course that the present invention can be applied to a so-called coreless board or the like.

According to a fifth aspect of the present invention, there is provided a method of manufacturing a wiring board including a stacked composite layer portion in which a polymer dielectric layer, a conductor layer and a ceramic dielectric layer made of ceramic of a high dielectric constant are stacked in this order so as to contact with each other, characterized by executing a first stacked layer assembly manufacturing step of manufacturing a first stacked layer assembly by forming a ceramic dielectric layer and a conductor layer in this order on one main surface of a transfer base plate, a second stacked layer assembly manufacturing step of manufacturing, separately of the first stacked layer assembly, a second stacked layer assembly having at a sticking surface side a polymer dielectric layer, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

By the method of manufacturing a wiring board according to a fifth aspect of the present invention, at the time of manufacturing a wiring board including a stacked composite layer portion in which a polymer dielectric layer, a conductor layer and a ceramic dielectric layer made of ceramic of a high dielectric constant are stacked in this order so as to contact with each other, a ceramic dielectric layer and a conductor layer are formed in this order on one main surface of a transfer base plate to form a first stacked layer assembly, the first stacked layer assembly is placed on a second stacked layer assembly having at a sticking surface side a polymer dielectric layer and stuck together therewith, and thereafter the transfer base plate is removed. Namely, the ceramic dielectric layer that is thin and fragile can be supplied to the sticking step by being reinforced by the transfer base plate and needs not to be handled by itself, thus making it possible to make dramatically higher the manufacturing efficiency and the yield rate of the wiring board having the stacked composite layer portion in which the polymer dielectric layer, conductor layer and the ceramic dielectric layer are stacked as described above.

In this invention, ceramic of a high dielectric constant indicates ceramic of the dielectric constant of 10 or more, and particularly when ceramic of a high dielectric constant is necessitated, it is desirable to employ ceramic having a strong dielectric property. As ceramic having a high dielectric constant are enumerated strong dielectric composite oxide ceramics having a perovskite crystal structure, for example, ceramic composed of one of or two or more of titanic acid barium, titanic acid strontium and lead titanate has a particularly high dielectric constant and its production is relatively easy, thus being able to be employed suitably in the present invention.

By employing, in the sticking step, a method of sticking the first stacked layer assembly and the second stacked layer assembly by applying thereto pressure in the stacking direction, the adhering strength of the conductor layer of the first stacked layer and the polymer dielectric layer of the second stacked layer after stuck together can be made higher.

In the stacked layer assembly to which the present invention is applied, the above-described composite layer unit can be structured so that the conductor layer is partially cut in the in-plane direction so as to have a conductor side cut portion, the ceramic dielectric layer is partially cut in the in-plane direction so as to have a ceramic side cut portion, the ceramic side cut portion and the conductor side cut portion are communicated to form a communication cut portion, and a polymer constituting the polymer dielectric layer is filled in the communication cut portion so as to extend through the conductor side cut portion to the ceramic side cut portion. By this, the polymer constituting the polymer dielectric layer is filled in the communication cut portion formed in the conductor layer and the ceramic dielectric layer, and therefore by the anchor effect the adhering strength can be made higher and a problem of peeling or the like at the time of reflow process or the like can be made hard to be caused.

The stacked wiring layer portion of such a structure can be produced in the following manner by using the manufacturing method of this invention. Namely, the first stacked layer assembly manufacturing step is executed in a way as to include a ceramic side cut portion patterning step of patterning the ceramic side cut portion in the ceramic dielectric layer formed on one main surface of the transfer base plate, a conductor layer forming step of forming a conductor layer on the ceramic dielectric layer after the patterning, and a conductor side cut portion patterning step of patterning the conductor side cut portion in the conductor layer in a way as to communicate the conductor side cut portion with the ceramic side cut portion. In the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on the main surface of the first stacked layer assembly on the side where the communication cut portion is open, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured. By this method, the uncured or semi-cured polymer constituting the polymer dielectric layer can be filled in the communication cut portion assuredly by sticking, and therefore the structure of the above-described wiring board can be obtained with ease.

The ceramic dielectric layer can be used as, besides a capacitor, a dielectric layer constituting a stacked distributed constant circuit assembly such as microstripline, stripline and coplanar waveguide. By forming a dielectric layer from a ceramic dielectric layer, the wavelength reduction rate of the line conductor included in the stacked distributed constant circuit assembly can be improved, thus contributing to making compact a circuit element (e.g., λ /4 transmission line). Further, since the transmission line width for obtaining equal characteristic impedance is reduced, miniaturization of the wiring portion can be attained with ease while satisfying a high frequency circuit's characteristic requirement, such as impedance matching. For example, by covering one main surface of a ceramic dielectric layer with a metallic surface conductor (e.g., functioning as a ground layer or power source layer) and by disposing, on the other hand, a transmission line conductor on the other main surface, a microstripline or a stripline structure can be obtained. In this instance, the transmission line conductor is referred to as a first conductor layer, and a polymer dielectric layer can be disposed to cover the transmission line conductor and contact the main surface, which serves as a background area of the transmission line conductor, of the above-described ceramic dielectric layer.

According to a sixth aspect of the present invention, there is provided a method of manufacturing a capacitor built-in type wiring board having a support base having formed therewithin a conductor extending vertically in the thickness direction, the support base being formed at first and second sides with respective stacked wiring layer portions in which a polymer dielectric layer and a conductor are stacked, only a first side wiring layer portion positioned on the first side being formed with a capacitor including a ceramic dielectric layer, chiefly characterized by comprising a step of forming a stacked composite layer portion in which a polymer dielectric layer, a conductor serving as one electrode of the capacitor and a ceramic dielectric layer are stacked in this order from the support base side so as to contact with each other, in such a manner that the stacked composite layer portion constitutes part of the first side stacked wiring layer portion and is formed on or included in the support base, a step of forming on the support base a polymer dielectric layer for constituting the second side stacked wiring layer portion, a step of making a via hole for forming a via conductor for interlayer connection in the first side stacked composite layer portion in a condition where the polymer dielectric layer is exposed to the second side, a step of cleaning the via hole formed on the first side with chemical fluid having a corrosion power of corroding polymer under the condition where the polymer dielectric layer is exposed to the second side, and a step of forming on an inner surface of the via hole a conductor that serves as a via conductor, stacking a second conductor layer on the ceramic dielectric layer from the side opposite to the first conductor layer and thereby constituting the capacitor by the first conductor layer, the ceramic dielectric layer and the second conductor layer, and a step of covering the second side polymer dielectric layer that is surface-roughened with chemicals, with another polymer dielectric layer and joining the new and old polymer dielectric layers together.

The capacitor built-in type wiring board does not differ from others in the structure for obtaining electrical connection between layers. Namely, electrical connection between the second conductor layer constituting the electrode of the capacitor and the conductor layer on the support base is obtained by the via conductor. The via hole for the via conductor can be formed by a laser irradiation technology or photolithographic technology, but when either of the technologies is employed, a cleaning step of cleaning the via hole is essential for preventing occurrence of defective connection. Though it is ideal that the cleaning step is applied only to the first side, it is employed in a batch process that attaches much importance to the productivity, a method of immersing an entire work in a cleaning tank in which chemicals are contained. Since the chemicals corrode polymer, the second side polymer dielectric layer is unavoidably surface roughed. In the above-described invention, the second side polymer dielectric layer is covered with another polymer dielectric layer. By this, a thick polymer dielectric layer that is formed by joining the new and old polymer dielectric layers together is formed. Namely, the polymer dielectric layer that is newly formed on the first side and the polymer dielectric layer on the second side can be made equal in the surface condition. As a result, it becomes possible to form plating layers that are equal in the thickness and quality on the first and second sides.

While it is considered, for preventing surface roughening of the second side polymer dielectric layer, to apply tape masking to the polymer dielectric layer at the time of cleaning of the first side via hole, such masking is not effective for correcting the inequality of the mechanical characteristics between the first side stacked wiring layer portion and the second side stacked wiring layer portion since the tape is removed later. According to the present invention, the strength of the second side stacked wiring layer portion can be increased since a deficiency for not being provided with a capacitor is made up by the thick polymer dielectric layer, and therefore the second side stacked wiring layer portion and the first side stacked wiring layer portion can be excellent in the strength balance, thus making it possible to attain a structure that is strong against bending and peeling.

In the above-described invention, the step of covering the polymer dielectric layer with another polymer dielectric layer can specifically be a step of laminating a polymer film or a step of applying polymer in a liquid state. Particularly, a method of laminating a build-up resin film (can be obtained from Ajinomoto Co., Inc.) of the equal thickness and characteristics is suitable. By this method, the device that is used in a usual build-up process can be used as it is, thus being contributive to suppression of the manufacturing cost. For the same reason, formation of the first side stacked wiring layer and the second side stacked wiring layer is proceeded by a build-up process in which the step of covering the second side polymer dielectric layer with another dielectric layer and the step of forming a new dielectric layer on the first side, are executed at the same period of time and other conductor layers are formed by a via forming step and a pattern plating step.

Further, the inventors noticed that at the time of formation of the stacked composite layer portion constituting a capacitor, there were the following technical problems (1) and (2) that were to be overcome.
(1) The adhering strength of the capacitor portion with respect to the build-up resin insulation layer and the conductor layer is liable to be lowered, and particularly when they are subjected to a thermal cycle due to a reflow process for flip-chip connection of electronic parts, the shearing stress level of the interlayer due to the difference in the linear expansion coefficient between the build-up resin insulation layer and the high dielectric ceramic layer becomes high, thus causing a problem such as peeling.
(2) The capacitor using a thin layer of high dielectric ceramic has a difficulty in handing at the time of connection to the build-up resin insulation layer for wiring, thus causing a problem of a bad manufacturing efficiency.

Such problems can be dealt with by the following procedure. Namely, the step of forming the stacked composite layer can be a step of executing a first stacked layer assembly manufacturing step of manufacturing a first stacked layer assembly by forming a ceramic dielectric layer and a conductor layer in this order on one main surface of a transfer base plate, a second stacked layer assembly manufacturing step of manufacturing a second stacked layer assembly by forming a polymer dielectric layer on a main surface of a support base, a sticking step of sticking the conductor layer of the first stacked layer assembly and the polymer dielectric layer of the second stacked layer assembly, and a transfer base plate removing step of removing the transfer base plate from the ceramic dielectric layer, in this order. By so doing, the ceramic dielectric layer that is thin and fragile can be supplied to the sticking step by being reinforced by the transfer base plate and needs not to be handled by itself, thus making it possible to make dramatically higher the manufacturing efficiency and the yield rate of the wiring board having the stacked composite layer portion in which the polymer dielectric layer, conductor layer and the ceramic dielectric layer are stacked as described above.

According to a seventh aspect of the present invention, there is provided a wiring board for mounting thereon an electronic part, characterized by comprising a support base having formed therewithin a through hole conductor extending vertically in the thickness direction, the support base being formed at first and second sides with stacked wiring layer portions in which a polymer dielectric layer and a conductor are stacked, respectively, only the first side wiring layer portion positioned on the first side being formed with a capacitor including a ceramic dielectric layer, the first side stacked wiring layer portion including a stacked composite layer portion in which a polymer dielectric layer, a conductor layer forming one electrode of the capacitor and a ceramic dielectric layer are stacked in this order from the support base side so as to contact with each other, a conductor constituting the other electrode of the capacitor being formed so as to cover the ceramic dielectric layer, the second side stacked wiring layer portion positioned on the second side including a polymer dielectric layer that is thicker than the polymer dielectric layer included in the first side stacked composite layer portion, at a layer level corresponding to the first side stacked composite layer portion when counted from the support base.

By the above-described invention, the second side stacked wiring layer portion has a thicker polymer dielectric layer instead of not having a capacitor. Namely, it becomes possible to approximate the mechanical characteristics of the first stacked wiring layer portion to those of the second stacked wiring layer portion and equally balance the strengths of the both. Accordingly, even if only the first side stacked wiring layer portion is configured to include a capacitor, a problem of bending or peeling can be made hard to be caused.

Further, in the above-described wiring board, it is desirable that the number of conductor layers of the second side stacked wiring layer portion positioned on the second side is smaller than the number of conductor layers of the first side stacked wiring layer portion. By so doing, the structure of the second side stacked wiring layer portion can be simplified.

According to a further aspect of the present invention, there is provided a wiring board characterized by comprising a stacked wiring layer portion in which a dielectric layer and a conductor layer are stacked is formed on at least one main surface of a support base, the stacked wiring layer portion including a stacked composite layer portion in which a polymer dielectric layer, a conductor layer and a ceramic dielectric layer are stacked in this order from the support base side so as to contact with each other, the conductor layer in the stacked composite layer portion being partially cut in the in-plane direction so as to have a conductor side cut portion, the ceramic dielectric layer being partially cut in the in-plane direction so as to have a ceramic side cut portion, the ceramic side cut portion and the conductor side cut portion being communicated to form a communication cut portion, a polymer constituting the polymer dielectric layer being filled in the communication cut portion so as to extend through the conductor side cut portion to the ceramic side cut portion.

With the structure of above-described the wiring board according to the seventh aspect of the present invention, it is adapted so that in a stacked composite layer portion in which a polymer dielectric layer, a conductor layer and a ceramic dielectric layer are stacked in this order from a core board portion side so as to contact with each other, the polymer constituting the polymer dielectric layer is filled in the communication cut portion formed in the conductor layer and the ceramic dielectric layer, and therefore by the anchor effect the adhering strength between the layers can be made higher and a problem such as peeling at the time of reflow process or the like can be made hard to be caused.

The above-described wiring board can be manufactured by using a manufacturing method according to the six aspect of the present invention as follows. Namely, the first stacked layer assembly manufacturing step is executed in a way as to include a ceramic side cut portion patterning step of patterning the ceramic side cut portion in the ceramic dielectric layer formed on one main surface of the transfer base plate, a conductor layer forming step of forming a conductor layer on the ceramic dielectric layer after the patterning, and a conductor side cut portion patterning step of patterning the conductor side cut portion in the conductor layer in a way as to communicate the conductor side cut portion with the ceramic side cut portion. In the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on the main surface of the first stacked layer assembly on the side where the communication cut portion is open, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured. By this method, the uncured or semi-cured polymer constituting the polymer dielectric layer can be filled in the communication cut portion assuredly by sticking, and therefore the structure of the above-described wiring board can be made simpler.

### BRIEF DESCRIPTION OF THE DRAWINGS

FIG. 1 is a cross sectional view of a wiring board according to an embodiment of the present invention.
FIG. 2 is a view showing a manufacturing step of the wiring board of FIG. 1.
FIG. 3 is a view showing a manufacturing step of the wiring board of FIG. 1.
FIG. 4 is a view showing manufacturing steps of the wiring board of FIG. 1.
FIG. 5 is a view showing manufacturing steps of the wiring board of FIG. 1.
FIG. 6 is a view showing manufacturing steps of the wiring board of FIG. 1.
FIG. 7 is a view showing a manufacturing step of the wiring board of FIG. 1.
FIG. 8 is a view showing a manufacturing step of the wiring board of FIG. 1.
FIG. 9 is a view showing a manufacturing step of the wiring board of FIG. 1.
FIG. 10 is a view showing manufacturing steps of the wiring board of FIG. 1.
FIG. 11 is a view showing manufacturing steps of the wiring board of FIG. 1.
FIG. 12 is a view showing manufacturing steps of the wiring board of FIG. 1.
FIG. 13 is a view showing manufacturing steps of the wiring board of FIG. 1.
FIG. 14A is a view schematically showing a diced package.
FIG. 14B is a view schematically showing a diced package.
FIG. 15A is an enlarged sectional view of a stacked wiring layer portion.
FIG. 15B is an enlarged sectional view of a stacked wiring layer portion.

### DETAILED DESCRIPTION OF THE INVENTION

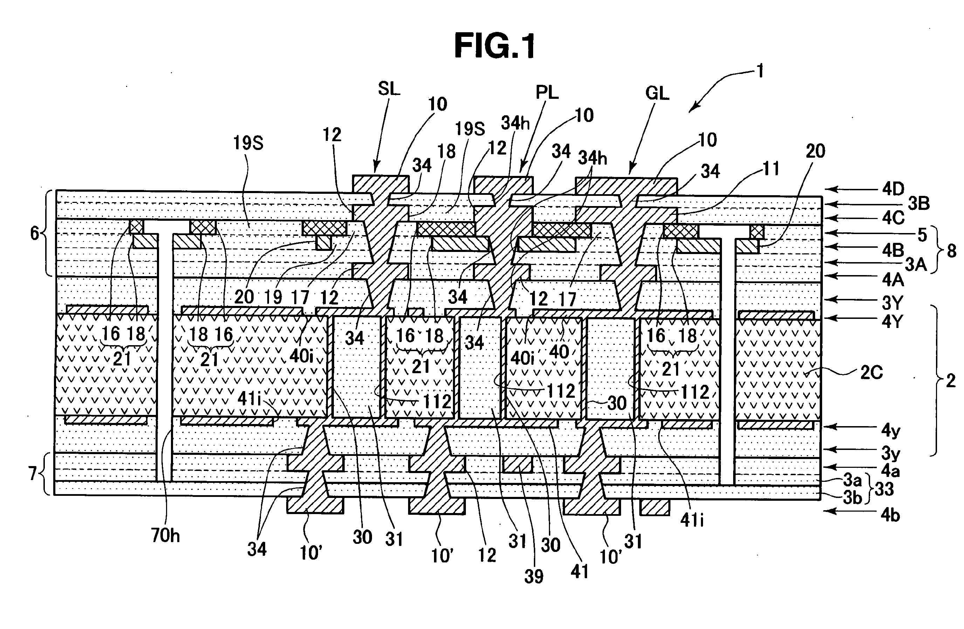

Hereinafter, an embodiment of the present invention will be described with reference to the drawings. FIG. 1 schematically shows a sectional structure of a wiring board 1 according to an embodiment of the present invention. The wiring board 1 is formed with, on both surfaces of a plate-shaped core 2c formed from a heat-resistant resin plate (e.g. , Bismaleimide-Triazine resin), fiber-reinforced resin plate (e.g., glass fiber-reinforced epoxy resin) or the like, core conductor layers 4Y, 4y constituting wiring metal layers of predetermined patterns, respectively. The core conductor layers 4Y, 4y are formed into plane conductor patterns covering almost all of the surfaces of the plate-shaped core 2c and used as a power source layer (41 in the drawing) or a grounding layer (40 in the drawing). On the other hand, the plated-shaped core 2c is formed with through holes 112 by a drill or the like, and on the inner wall surfaces of the through holes are formed through hole conductors 30 for electrically connecting the core conductor layers 4Y, 4y with each other. Further, the through holes 112 are filled with a resin filler material 31 such as epoxy resin.

Further, above the core conductor layers 4Y, 4y are respectively formed first via layers (build-up layer: dielectric layer) made of epoxy resin or the like polymer (and inorganic filler made of silica powder or the like for adjustment of the dielectric and the insulation resisting pressure: this is similar in other polymer dielectric layers). Further, on the surfaces of the via layers are formed by Cu-plating third conductor layers 4A, 4a. In the meantime, the core conductor layers 4Y, 4y and the third conductor layers 4A, 4a are interlayer-connected by vias 34. Similarly, above the third conductor layers 4A, 4a are formed second via layers 3A, 3a, respectively. A core board portion 2 is made up of the plate-shaped core 2c, core conductors 4Y, 4y and first via layers 3Y, 3y.

On the first main surface side (the main surface shown at the upper side in the drawing) of the core board portion 2, a first polymer dielectric layer 3A, a first conductor layer 4B made up of a Cu-plating layer, a ceramic dielectric layer 5, a second conductor layer 4C made up of a Cu-plating layer, a second polymer dielectric layer 3B and a fourth conductor layer 4D formed with a plurality of terminal pads 10 for connection with electronic parts are stacked in this order on the third conductor layer 4A for thereby forming a first stacked wiring layer portion 6. The fist conductor layer 4B, the second conductor layer 4C and the fourth conductor layer 4D are electrically connected in the stacked direction, by way of respective intermediate pads 12, by vias 34 that are formed as filled plating portions of Cu. Further, on the second main surface side (the main surface shown at the lower side in the drawing), a rear side third conductor layer 4a, a polymer dielectric layer 3a and a rear side first conductor layer 4b including rear side metal terminal pads 10' are stacked in this order on the first via layer 3y for thereby forming a second side stacked wiring layer portion 7. The rear surface side metal terminal pads 10' are used as rear surface pads for connecting the wiring board 1 itself to a motherboard or the like by pin grid array (PGA) or ball grid array (BGA).

There are three kinds of conduction paths each consisting of the via 34, intermediate pad 12 and through hole conductor 30 for connection between the terminal pad 10 and the rear surface side terminal pad 10', i.e., a signal conduction path SL, power source conduction path PL and grounding conduction path GL. In the meantime, the through hole conductor 30 included in the signal conduction path SL is insulated from a power source layer 41 and a grounding layer 40 by means of insulation gap portions 40i, 41i. Further, the through hole conductor 30 included in the power source conduction path PL and the through hole conductor 30 included in the grounding conductor path GL are insulated from the grounding layer 40 by means of the insulation gap portion 40i and from the power source layer 41 by means of the insulation gap portion 41i, respectively.

As described above, the wiring board 1 is formed with, on at least one main surface of the core board portion 2, a stacked wiring layer portion 6 in which a dielectric layer and a conductor layer are stacked, and the stacked wiring layer portion 6 includes a stacked composite layer portion 8 in which the polymer dielectric layer 3A, the conductor layer 4B and the ceramic dielectric layer 5 (determined to have such a conception as to include a notched portion 16: a ceramic layer excluding the notched portion 16 is indicated by 15) are stacked in this order so as to contact with each other.

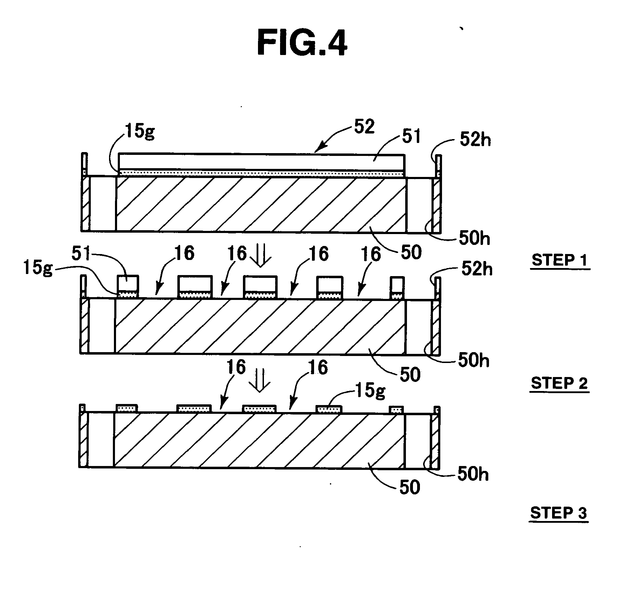

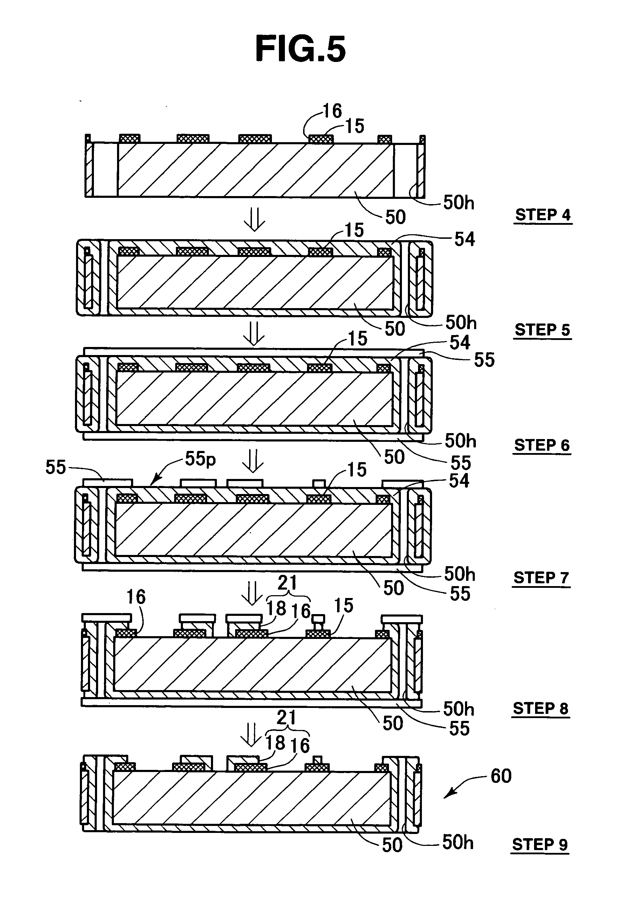

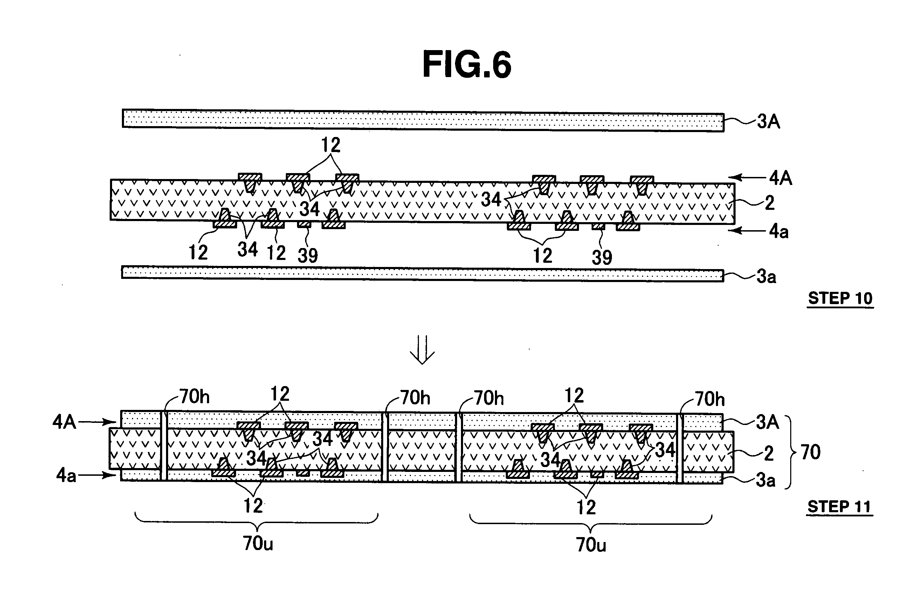

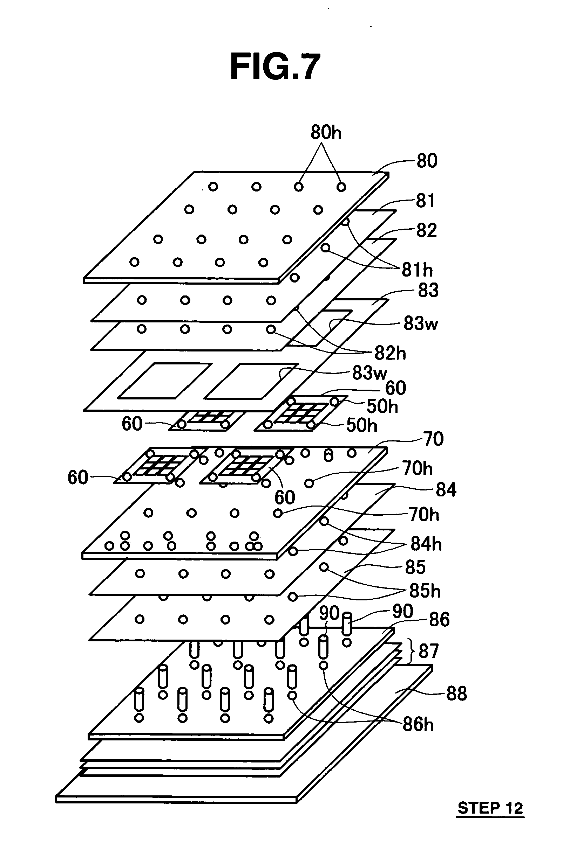

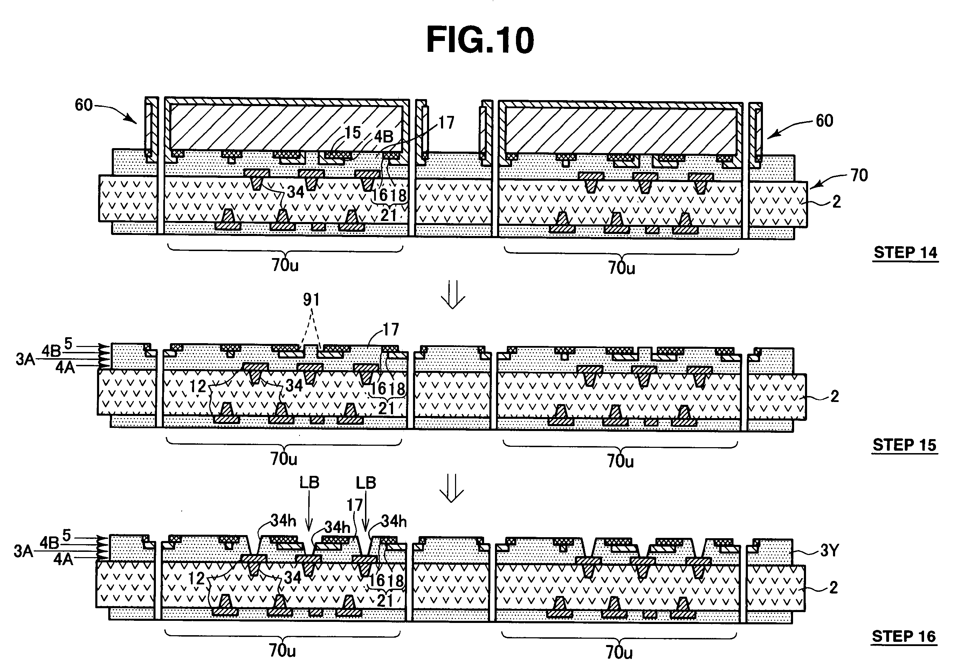

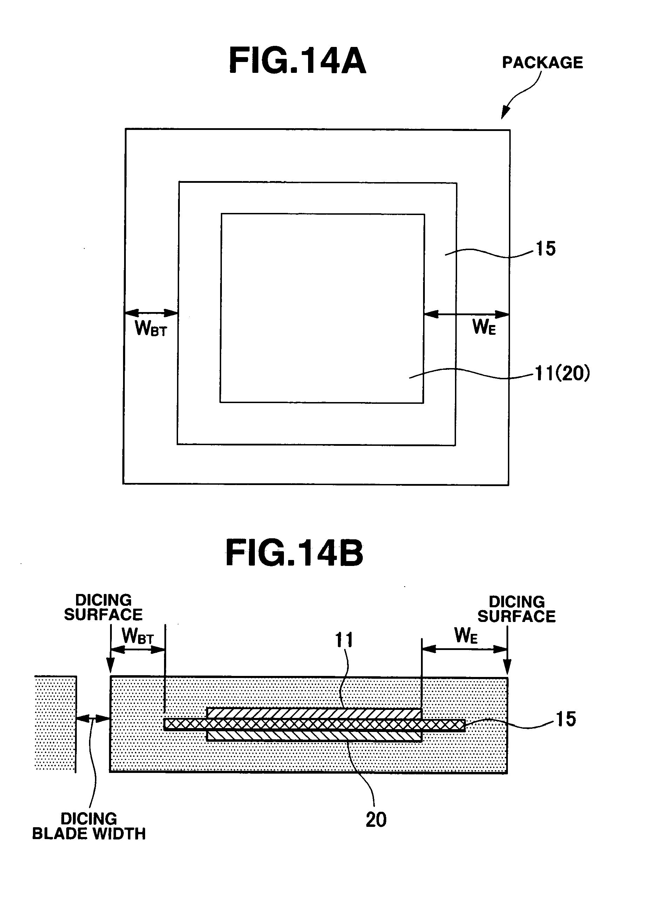

For manufacturing such a wiring board 1, a wiring board manufacturing method of the present invention has the following important features.
(1) The ceramic dielectric layer 5 and the conductor layer 4B are formed in this order on one main surface of a transfer base plate 50 for thereby forming the first stacked layer assembly 60 (first stacked layer assembly manufacturing step: steps 1 to 9 in FIGS. 4 and 5) .
(2) The polymer dielectric layer 3A is formed on the main surface of the core board portion 2 for thereby manufacturing a second stacked layer assembly 70 (second stacked layer assembly manufacturing step: steps 10 and 11 in FIG. 6).
(3) The conductor layer 4B of the first stacked layer assembly 60 and the polymer dielectric layer 3A of the second stacked layer assembly 70 are stuck together (sticking step: steps 12 and 13 in FIGS. 7 to 9).
(4) The transfer base plate 50 is removed from the ceramic dielectric layer 5 (transfer base plate removing step: steps 14 and 15 in FIG. 10).
(5) One (panel) that is obtained by sticking the first stacked layer assembly 60 and the second stacked layer assembly 70 together is diced into individual units (package) of wiring boards 1 (FIGS. 14A and 14B).

By the wiring board manufacturing method of the present invention, the first stacked layer assembly 60 is manufactured by forming the ceramic dielectric layer 5 and the conductor layer 4B in this order on one main surface of the transfer base plate 50, then stacked on the second stacked layer assembly 70 in which the polymer dielectric layer 3A is formed on the main surface of the core board portion 2 and stuck thereto, and diced into individual units 70u of the wiring boards 1 after the transfer base plate 50 is removed. Namely, the ceramic dielectric layer 5 that is thin and fragile can be supplied to the sticking step by being reinforced by the transfer base plate 50 and needs not to be handled by itself, thus making it possible to make dramatically higher the manufacturing efficiency and the yield rate of the wiring board 1 having the stacked composite layer portion 8 in which the polymer dielectric layer 3A, conductor layer 4B and the ceramic dielectric layer 5 are stacked as described above.

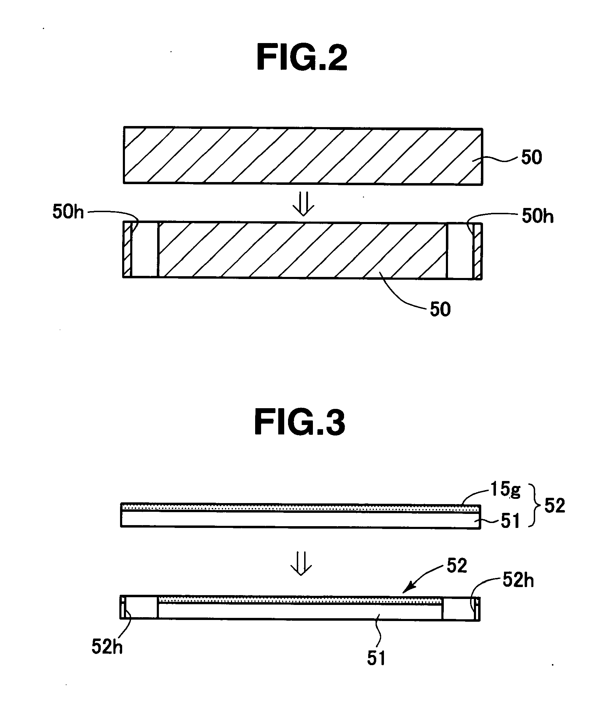

In the sticking step, as shown in FIGS. 7 to 9, by inserting positioning pins 90 into guide through holes 50h, 70h formed in the first stacked layer assembly 60 and the second stacked layer assembly 70, respectively, the first stacked layer assembly 60 and the second stacked layer assembly 70 can be stuck together while being positioned relative to each other. By this, pattern deviation of the ceramic dielectric layer 5 and the conductor layer 4B stacked to contact therewith on the first stacked layer assembly 60 side, from the polymer dielectric layer 3A on the second stacked layer assembly 70 side can be prevented effectively. In this embodiment is used such a transfer base plate 50 that is, as shown in FIG. 2, formed with the guide through holes 50h by drilling or the like.

As the transfer base plate 50 can be used a metal base plate 50 of a melting point that is higher than a sintering temperature of ceramic that constitutes the ceramic dielectric layer 5. In this instance, the above-described first stacked layer assembly manufacturing step is executed so as to include a non-sintered green ceramic layer forming step of forming a non-sintered green ceramic layer 15g that is made of a non-sintered material of the ceramic dielectric layer 5 (steps 1 to 3 in FIG. 4) and a sintering step of sintering the non-sintered green ceramic layer 15g together with the metal base plate 50 (step 4 in FIG. 5).

It is important for improvement in the dielectric constant (particularly, in case of strong dielectric ceramic) that the ceramic dielectric layer is formed as a crystalline layer such that employment of sintered ceramic is effective. By using the metal base plate 50 of the melting point higher than the sintering temperature of the ceramic constituting the ceramic dielectric layer 5 as the transfer base plate 50, the transfer base plate 50 can be used, at the time of sintering of the non-sintered green ceramic layer 15g, for its handling and there is not caused any problem by allowing the transfer base plate 50 to have such a thermal history of being subjected to sintering together with the ceramic dielectric layer 5 such that handling of the green ceramic layer can be quite easy.

In the meantime, the ceramic dielectric layer 5 can be formed by chemical vapor deposition such as sputtering method or chemical solution deposition such as sol-gel method. However, in case the chemical vapor deposition is employed, it is important to produce films while heating a plate-shaped base and thereby accelerate crystallization, and in case the chemical solution deposition is employed, it is important to accelerate crystallization of films by the sintering process after drying.

Suitably employed for the ceramic dielectric layer 5 that is, for example, used for a capacitor are, for improvement in the electrostatic capacity, composite oxides having a perovskite crystal structure, for example, ceramic composed of one of or two or more of titanic acid barium, titanic acid strontium and lead titanate since they have a particularly high dielectric constant and relatively easy in manufacture. In this instance, as the above-described metal base plate 50 can be used a Fe-based or Ni-based metal plate and a Mo-based, W-based, Ta-based or the like metal plate having a higher melting point.

The non-sintered green ceramic layer 15g can be a ceramic green sheet 15g that is formed by mixing ceramic powder with a polymer binding material (so-called binder) and forming it into a sheet-shape. The thin ceramic green sheet 15g can be manufactured easily by a doctor-blade process or the like and can be handled with ease since it has a large flexibility. The thickness of the ceramic dielectric layer 5 by sintering is, for example, in the range from 1 *µ*m to 100 *µ*m. The ceramic dielectric layer 5 is made of high dielectric ceramic of the dielectric constant of 10 or more.

The ceramic dielectric layer 5 needs to be patterned into a suitable shape for forming vias that will be described later, capacity adjustment of a capacitor, etc. However, ceramic dielectric is not easy to be patterned by chemical etching since it is chemically stable and also has a difficulty in being patterned by laser or the like when in a state of being densified by sintering due to its high melting point. However, by using the following method, the above-described patterning can be executed with ease. Namely, the ceramic green sheet 15g is stuck onto the metal base plate 50 (step 1 in FIG. 4), then the ceramic green sheet 15g is patterned into the shape of the ceramic dielectric layer 15 to be obtained (step 2) and thereafter the sintering step is executed (step 4 in FIG. 5). Since the ceramic green sheet 15g is in a state of ceramic power being bound by a binding polymer material, an unnecessary part of the sheet can be removed easily by laser irradiation. In the meantime, a similar method of forming the ceramic dielectric layer 5 by sintering a non-sintered dry ceramic layer attained by the sol-gel method can attain the same effect.

As shown in FIG. 3, the ceramic green sheet 15g can be formed on a carrier sheet 51 made of polymer (e.g., polyethylene terephthalate resin sheet). This enables the ceramic green sheet 15g to be produced by the doctor blade method or the like with high efficiency. Specifically, slurry is formed by mixing ceramic powder, polymer binding material, dispersant, plasticizer, solvent, etc., then applied onto the carrier sheet 51 and dried into the ceramic green sheet 15g.

The green sheet 15g is formed into a long, narrow ceramic green sheet 52 with a carrier sheet by performing application of slurry while unwinding the wound-up carrier sheet 51. From the point of view of attaining a strength at the time of manufacture of the green sheet, such as application of slurry and drying, and from the point of view of the parting ability of the ceramic green sheet 15g, it is desirable that the carrier sheet 51 is made of polyethylene terephthalate resin.

It is desirable that the thickness of a ceramic dielectric layer obtained by sintering, if it is used for forming a capacitor with a high capacitance, is adjusted so as to be in the range from 1 *µ*m to 100 *µ* m. Accordingly, it is desirable that the thickness of the ceramic green sheet 15g used for forming the ceramic dielectric layer by sintering is adjusted so that the above-described thickness after sintering is obtained (e.g., from 2 *µ*m to 200 *µ*m). On the other hand, the ceramic green sheet 52 with a carrier sheet, when used for forming a board (stacked assembly), needs to be cut to a suitable size before use. In case the thickness of the ceramic green sheet 15g is adjusted so as to be small as described above, a problem on the accuracy of cut, such as a crack adjacent a cutting blade, is liable to occur. To avoid such a defect, it is desirable that the thickness of the carrier sheet 51 made of polyethylene terephthalate resin is set to 20 µm or more. In the meantime, though there is not an upper limit on the thickness of the carrier sheet 51, a suitable flexibility that contributes to convenience of winding, etc. can be obtained if the thickness is set equal to or smaller than 100 *µ*m.

The ceramic green sheet 52 with a carrier sheet after cutting is formed with guide through holes 52h by punching or the like. Further, as shown in FIG. 2, the metal base plate 50 is also formed with guide through holes 50h at corresponding positions. The guide through holes 50h can be formed by chemical etching with ease (particularly, in case the thickness of the metal base plate is 100 *µ*m or smaller (in consideration of handling, 20 *µ* m or more)). Specifically, the guide through holes are formed by covering the main surfaces of the metal base plate 50 with etching resists, forming etching windows corresponding in shape to the guide through holes, in the etching resists and dipping the metal base plate with etching resists in etching solution. The same etching solution (will be described later) as that used for removing the metal base plate 50 can be used.

In this case, as shown in the step 1 of FIG. 4, the ceramic green sheet 15g in a state of being integrally joined at the side opposite to the sticking surface, with the carrier sheet 51, is stuck onto the metal base plate 50, then as shown in step 2 the ceramic green sheet 15g in this state is laser patterned together with the carrier sheet 51, and thereafter as shown in step 3 the carrier sheet 51 is removed for thereby enabling execution of a sintering step. When the ceramic green sheet 15g is laser patterned together with the carrier sheet 51, scattered masses of the ceramic green sheet 15g burnt and scattered can be removed together with the carrier sheet 51 since the area around the patterned region is protected by the carrier sheet 51, and further there can be obtained such an advantage that contamination due to the scattered masses is hard to be caused on the ceramic green sheet 15g after patterning.

In case the process of sintering the non-sintered green ceramic layer 15g together with the metal base plate 50 is employed, the second stacked layer assembly 70 including the core board portion 2 is, as shown in step 11 of FIG. 6, in-plane integrated with a plurality of units 70u of wiring boards to be manufactured (specifically, a portion of the second stacked layer assembly 70 constitutes a portion of a single unit of wiring board) . As shown in step 10 of FIG. 6, the second stacked layer assembly 70 is formed with, at the both main surfaces of the core board portion 2 that is prepared beforehand, the polymer dielectric layers 3A, 3a and is further formed with guide through holes 70h as shown in step 11. The guide through holes 70h are formed at the respective four corners of each unit 70u.

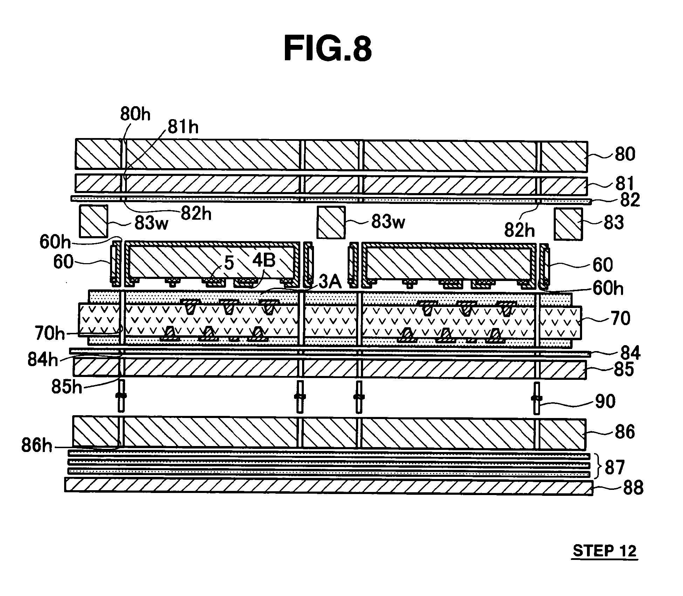

In the sticking step, it is effective to employ a step of arranging and disposing on the second stacked layer assembly 70, as shown in FIG. 7, a plurality of first stacked layer assemblies 60 each including units 70u (specifically, a portion of the first stacked layer assembly 60 that constitutes a portion of a single unit of wiring board) that are smaller in number than those of the second stacked layer assembly 70 (specifically, a portion of the second stacked layer assembly 70 that constitutes a portion of a unit of the wiring board). The non-sintered ceramic green sheet 15g is caused to shrink by sintering such that there is a possibility that if the metal base plate 50 having a large area is used, bending of the obtained first stacked layer assembly 60 becomes large by the influence of the shrinkage. However, by separately disposing a plurality of first stacked layer assemblies 60 relative to the second stacked layer assembly 70, the influence of bending at the time of sintering can be kept smaller as compared with that in case the first stacked layer assemblies 60 are all formed into an integral unit. In this instance, as shown in FIG. 8, by inserting the positioning pins 90 into the guide through holes 60h formed at the respective four corners of the first stacked layer assemblies 60 and the guide through holes 70h on the second stacked layer assembly 7 side and thereby positioning the respective first stacked layer assemblies 60 relative to the second stacked layer assembly 70 and sticking them together, the accuracy in positioning of the respective first stacked layer assemblies 60 relative to the second stacked layer assembly 70 can be improved.

In the transfer base plate removing step, the metal base plate 50 can be removed by chemical etching. By this method, the metal base plate 50 can be removed while restricting mechanical damage to the thin ceramic dielectric layer 5 to minimum. In case the metal base plate 50 made of Fe-based or Ni-based metal is used, etchants such as iron(III) chloride solution, copper(II) chloride solution and acid solution as hydrochloric acid can be used. In the meantime, the metal base plate 50 can be chemically etched in its entirety, or in case the metal base plate 50 made of Fe-based metal or Ni-based metal is used, the metallic base metal 50 can be composed of a main body layer and a separation layer having a higher Fe content than the main body layer such that the separation layer is etched for separation of the main body layer and thereby enabling to reduce the entire etching amount of the base metal.

Returning back to FIG. 1, the wiring board 1 has the stacked composite layer portion 8 in which the conductor layer 4B is partially cut in the in-plane direction to have a conductor side cut portion 18 and the ceramic dielectric layer 5 is partially cut in the in-plane direction to have a ceramic side cut portion 16, the ceramic side cut portion 16 and the conductor side cut portion 18 being communicated to form a communication cut portion 21, a polymer constituting the polymer dielectric layer 3A being filled in the communication cut portion 21 so as to extend through the conductor side cut portion 18 to the ceramic side cut portion 16.

With the structure of above-described the wiring board 1 of the present invention, it is adapted so that in the stacked composite layer portion 8 in which the polymer dielectric layer 3A, the conductor layer 4B and the ceramic dielectric layer 4B are stacked in this order from the core board portion 2 side so as to contact with each other, the polymer constituting the polymer dielectric layer 3A is filled in the communication cut portion 21 formed in the conductor layer 4B and the ceramic dielectric layer 5, and therefore by the anchor effect the adhering strength between the layers can be made higher and a problem of peeling or the like at the time of reflow process or the like can be made hard to be caused.

The above-described structure can be obtained by executing a first stacked layer assembly manufacturing step as follows.
(1-1) The ceramic side cut portion 16 is patterned in the ceramic dielectric layer 15g formed on one main surface of the transfer base plate 50 (ceramic side cut portion patterning step: step 3 of FIG. 4).
(1-2) The conductor layer 54 (which will become the conductor layer 4B later) is formed on the ceramic dielectric layer 15 after the patterning (conductor layer forming step: step 5 of FIG. 5).
(1-3) The conductor side cut portion 18 is patterned in the conductor layer 4B in a way as to communicate the ceramic side cut portion 16 (conductor side cut portion patterning step: steps 6 to 9).

In FIG. 5, as shown in step 5, the conductor layer 54 is formed as a Cu-plating layer enclosing the entire of the transfer base plate 50 and the patterned and sintered ceramic dielectric layer 15. In step 6, a photosensitive etch resist layer 55 is formed, and in step 7 the etch resist layer is exposed and developed for thereby patterning etched windows 55p. After the etching of the conductor layer 54 using the etch resist layer 55 as shown in step 8, the etch resist layer 55 is removed as shown in step 9.

In the meantime, in the step of patterning the etched windows 55p by exposure and development of the photosensitive etch resist layer 55 (step 7 in FIG. 5) , the etched window 55p is patterned as schematically shown in FIGS. 14A and 14B so that an external end surface of a first electrode 20 is withdrawn (inwardly) from the end surface of the unit (package) 70u of the wiring board 1 at least by a second withdrawal width W_{E} (>W_{BT}) in consideration of the external size of the unit (package) 70u of the wiring board 1 to be manufactured and a dicing blade width in a dicing step carried out later and its error. The second withdrawal width W_{E} is desired to be in the range from 0.8 mm to 2.5 mm, for example, set to 1.0 mm. If the second withdrawal width W_{E} is smaller than 0.8 mm, there is a possibility that sagging of the first electrode 20 will occur to cause shortage. Further, if the second withdrawal width is larger than 2.5 mm, the area of the first electrode 20 becomes undesirably small. The second withdrawal width W_{E} is similarly set with respect to the second electrode 11. By determining, in this manner, the value of the second withdrawal width W_{E}, in addition to that the external end surface of the ceramic dielectric layer 15 constituting a capacitor is withdrawn from (formed inward of) the package end surface, the external end surfaces of the first electrode 20 and the second electrode 11 are withdrawn from (formed inward of) the external end surface of the ceramic dielectric layer 15 such that the capacitor can be prevented from being exposed to the package end surface to assuredly prevent shortage between the layers.

As shown in FIGS. 7 and 8, in the sticking step, on the main surface of the first stacked layer assembly 60 formed with the communication cut portion 21 consisting of the ceramic side cut portion 16 and the conductor side cut portion 18 communicated with the ceramic side cut portion, which main surface is on an open side of the communication cut portion 21, is stacked the second stacked layer assembly 70 having the polymer dielectric layer 3A in an uncured or semi-cured state at the main surface of the polymer dielectric layer 3A. Herein, an upper base 80 (having guide through holes 80h), an auxiliary plate 81 made of stainless steel or the like (having guide through holes 81h), parting film 82 (having guide through holes 82h), a spacer 83 formed with accommodation portions 83w for the respective first stacked layer assemblies 60, the first stacked layer assemblies 60, and the second stacked layer assembly 70, a parting film 84 (having guide through holes 84h), an auxiliary plate 85 made of stainless steel or the like (having guide through holes 85h), a lower base 86 (having pin retaining holes 86h for retaining base end portions of positioning pins 90), cushion sheets 87 and a carrier plate 88 are stacked in this order from the upper side.

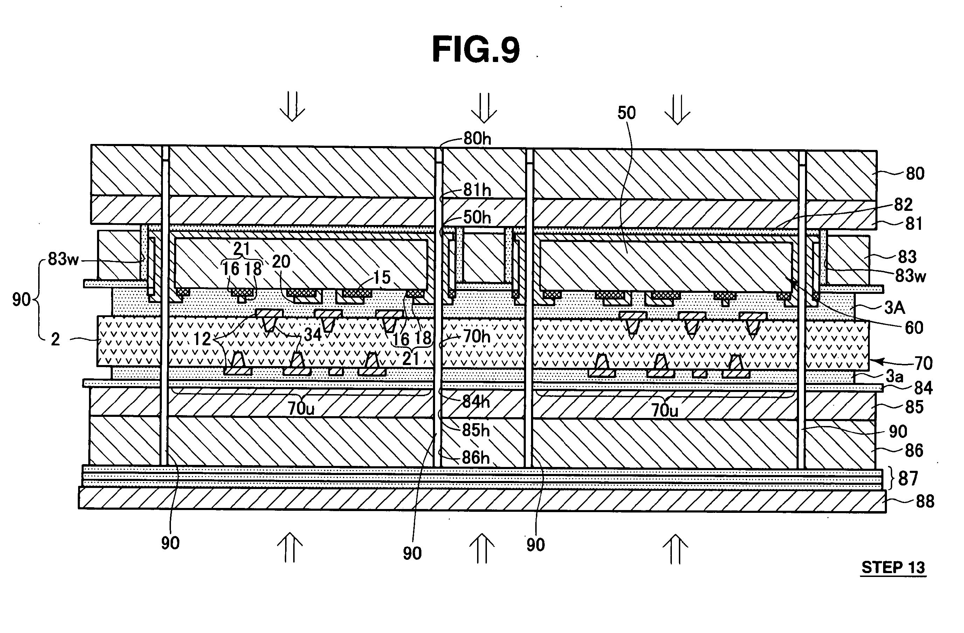

As shown in FIG. 9, by using a known hydraulic press or the like though not shown, the above-described stacked assembly is pressed together. By pressing the first stacked layer assembly 60 and the second stacked layer assembly 70 in the stacked direction, the uncured or semi-cured polymer constituting the polymer dielectric layer 3A is pressed into the communication cut portion 21. Thereafter, the polymer is cured by heating, etc. The uncured or semi-cured polymer constituting the polymer dielectric layer 3A can be assuredly filled in the communication cut portion 21 by sticking under pressure, thus making it possible to obtain the above-described wiring board 1 with ease.

At the time of pressing for transfer of a plurality of first stacked layer assemblies 60 onto the second stacked layer assembly 70, by disposing the spacer 83 made from a metal plate of the same thickness as the first stacked layer assembly 60 in the blank space, the pressing can be carried out without any difference in level and unnecessary flow of the polymer can be prevented. For example, since the thickness of the first stacked layer assembly 60 at the time of transfer pressing is in the range from 0.1 mm to 1 mm (preferably, from 0.235 mm to 0.360 mm), a metal plate (e.g., stainless steel plate) having the thickness in the range from 0.1 mm to 1 mm (preferably, from 0.235 mm to 0.360 mm) is used for the spacer 83.

Returning to FIG. 1, the wiring board 1 has, when the conductor layer 4B included in the stacked composite layer portion 8 is referred to as a first conductor layer 4B, a second conductor layer 4C stacked on the ceramic dielectric layer 5 from the side opposite to the first conductor layer 4B such that the first conductor layer 4B, the ceramic dielectric layer 5 and the second conductor layer 4C can constitute a capacitor. The first conductor layer 4B is formed with the first electrode 20 of the capacitor and the second conductor layer 4C is formed with the second electrode 11. One of the first electrode 20 and the second electrode 11 is connected to the conduction path PL for power source, and the other is connected to a conduction path PL for grounding. In the meantime, while by forming cut portions for passage of the vias 34, etc., the first electrode 20 and the second electrode 11 are shown so as to be separated in the in-plane direction and be small in the in-plane projected area, they actually form, in the in-plane direction, a continuous thin layer at a portion other than the cut portions and the in-plane projected area is far larger than that shown in the section. This is the same with the ceramic dielectric layer 5. By this structure, a capacitor for decupling, etc. can be installed in the stacked wiring layer portion 6 including a polymer dielectric layer (build-up layer) such that external attachment for disposing an intermediate board having installed therein a capacitor, between the wiring board and an electronic device (not shown) becomes unnecessary, thus contributing to reduction in the height of the assembly. In this case, it is desired to form, after the transfer base plate removing step is finished, the second conductor layer 4C on the transfer base plate 50-removed main surface side of the ceramic dielectric layer 5.

With the structure in which the first conductor layer 4B, the ceramic dielectric layer 5 and the second conductor layer 4C constitute a capacitor, the conductor pattern (second electrode) 11 constituting part of the second conductor layer 4C is disposed so as to contact, at least at one of the communication cut portions 21, a ceramic side polymer filled portion 17 filling the ceramic side cut portion 16, on the side opposite to that at which it communicates the conductor side cut portion 18. The boundary surface between the conductor pattern 11 and the ceramic side polymer filled portion 17 is formed flush with the second conductor layer 4C side main surface of the ceramic dielectric layer 5. By this, the flatness of the second conductor layer 4C side main surface of the ceramic dielectric layer 5 is improved, and this contributes to the flatness of the surface of the stacked wiring layer portion 6 such that, for example, the coplanarity of the pad 12 for connection with an electronic device, which is formed at an outermost surface part of the stacked wiring layer portion 6 can be improved.

Such a structure, as described above, can be formed with ease by pressedly inserting, in the sticking step, polymer into communication cut portion 21 and curing it, thereby forming the ceramic side polymer filled portion 17 so as to make it, by the main surface of the transfer base plate 50, flush with the ceramic dielectric layer 5 (step 14 of FIG. 10) and thereafter executing the transfer base plate removing step (step 15).

Returning back to FIG. 1, the wiring board 1 is formed with the third conductor layer 4A that contacts the polymer dielectric layer 3A at the side opposite to the first conductor layer 4B, the conductor pattern 11 constituting the second conductor layer 4C and the third conductor layer 4A being conductively connected by via 34 that penetrates the ceramic dielectric layer 5, the first conductor layer 4B and the polymer dielectric layer 3A in this order, the first conductor layer 4B and the via 34 being insulated from each other by the polymer filling the conductor side cut portion 18, the through hole 34h for forming a via in the ceramic side cut portion 16 being formed in the ceramic side polymer filled portion 17 filling the ceramic side cut portion 16. With this structure, the ceramic dielectric layer 5 intrinsically having an insulation function is not directly formed with a through hole for via but the ceramic side polymer filled portion 17 disposed inside is formed with the through hole such that an advantage of the through hole 34h being formed with ease can be attained. Specifically, as shown in steps 15 and 16 of FIG. 10, the ceramic side polymer filled portion 17 can be formed with, from the main surface side exposed by removal of the transfer base plate 50, the through holes 34h by laser LB (laser process) with ease. Laser LB is CO² laser, YAG laser or exima laser. A method of drilling the via holes 34h by a photolithographic technology can be employed other than the method of drilling the via holes 34h by laser process.

Further, in the wiring board 1, the second conductor side cut portion 18 is formed, by partially cutting the second conductor layer 4C in the in-plane direction, so as to communicate part of the communication cut portion 21. A second conductor side polymer filled portion 19S filling the second conductor side cut portion 18 is joined, at the area communicating the communication cut portion 21, to the ceramic side polymer filled portion 17 filling the ceramic side cut portion 16 while being partially extended over the main surface side of the ceramic dielectric layer 5. By this, a structure in which the inside, front and rear of the communication cut portion 21 are integrally connected by polymer can be obtained, and by the second conductor side polymer filled portion 19S extended, from the periphery of the communication cut portion 21, over the main surface side of the ceramic dielectric layer 5, the edge portion of the communication cut portion 21, including the side surface, is embedded in the polymer. As a result, peeling of the ceramic dielectric layer 5 at the border of the main surface of the ceramic dielectric layer 5 is hard to be caused. This effect is particularly enhanced when the communication cut portion 21 and the second conductor side cut portion 18 are formed along the outer periphery of the ceramic dielectric layer 5.

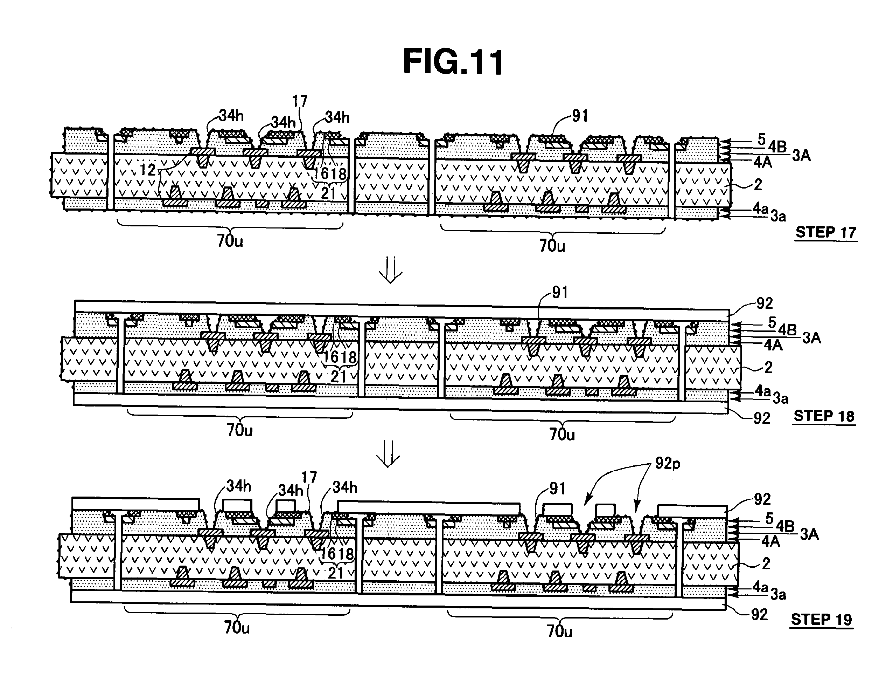

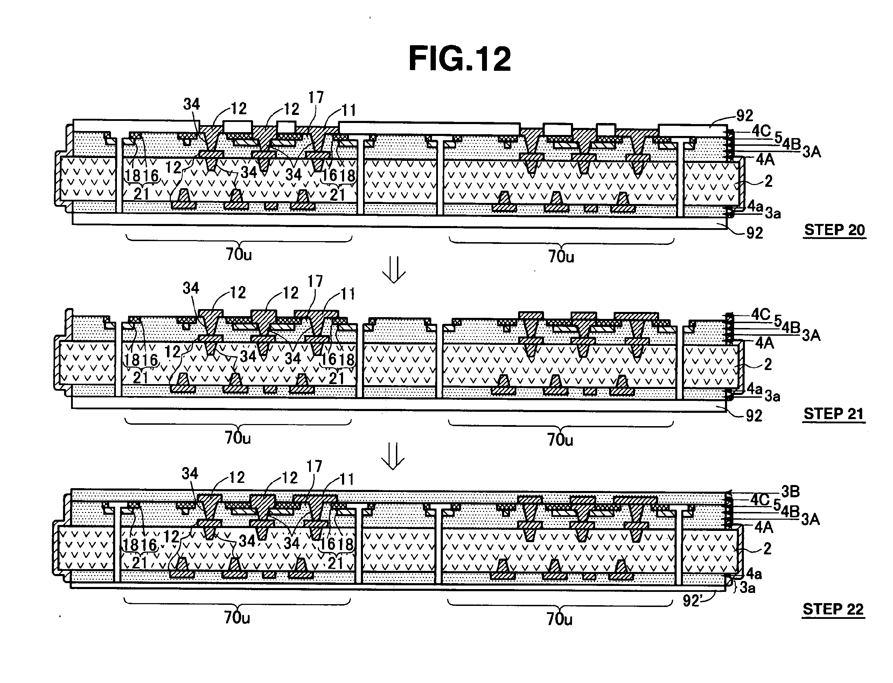

The above-described structure can be obtained with ease by the method of forming the second conductor layer 4C after the transfer base plate removing step is finished, forming the second conductor side cut portion 18 so as to communicate part of the communication cut portion 21 (from step 17 of FIG. 11 to step 21 of FIG. 12), forming and stacking another polymer dielectric layer 3B on the main surface of the second conductor layer 4C formed with the second conductor side cut portion 18 (step 22) and filling the polymer constituting the polymer dielectric layer 3B into the second conductor side cut portion 18 to be joined to the ceramic side polymer filled portion 17.

In step 17, the exposed surface portion and the inner surface of the via hole 34h of the ceramic side polymer filled portion 17 are covered by a nonelectrolytic Cu-plating layer 91 for plating conduction, and in step 18 a plating resist layer 92 is further formed. In step 19, the plating resist layer 92 is exposed and developed to form plating windows 92p corresponding to the portions to be plated.

In the meantime, in the step of patterning the plating windows 92p by exposing and developing the plating resist layers 92 (step 19 of FIG. 11), as schematically shown in FIGS. 14A and 14B, the plating windows 92p are patterned so that the external end surface of the second electrode 11 that is formed in the next step (step 20 of FIG. 12) is withdrawn from a dicing surface by at lease the second withdrawal width W_{E} (>W_{BT}) in consideration of the external size of the unit (package) 70u of the wiring board 1 and the dicing blade width and its error in the dicing step that is carried out later.

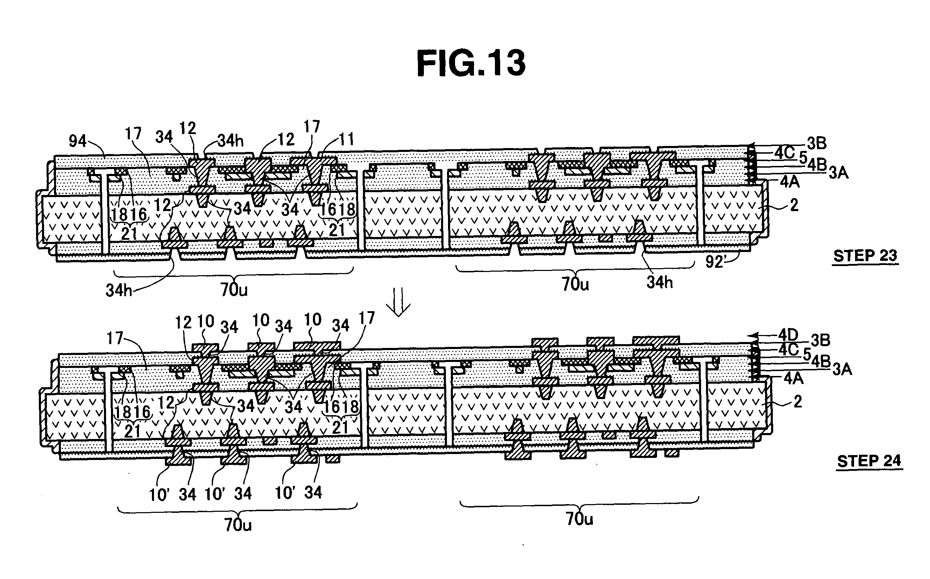

In step 20 of FIG. 12, via filling plating for filling the inside of the via holes 34h with plating is carried out by electrolytic Cu-plating to form the vias 34 and the intermediate pads 12. In step 21, the plating resist layer 92 is removed, and the nonelectrolytic Cu-plating layer that is not formed with electrolytic Cu-plating but exposed is removed by quick etching for thereby forming the second conductor layer 4C formed with the second conductor side cut portion 18. Thereafter, in step 22, the polymer dielectric layer 3B is formed. Then, in step 23 of FIG. 13, the polymer dielectric layer 3B is formed with the via holes 34h, and in step 24 the vias 34 filling the via holes 34h and the terminal pads 10, 10' are formed by plating.

Finally, the panel obtained by step 24 is diced by an unshown, known dicing machine into individual packages each constituting a unit 70u of wiring board 1 as schematically shown in FIGS. 14A and 14B. In this instance, as already described, the external end surface of the ceramic dielectric layer 15 is formed so as to withdraw from the dicing surface by at least a first withdrawal width W_{BT} (steps 2 and 3 of FIG. 4), and the external end surfaces of the first electrode 20 and the second electrode 11 are formed so as to withdraw from the dicing surface by at least the second withdrawal width W_{E} (step 8 of FIG. 5, step 20 of FIG. 12) such that the ceramic dielectric layer 15, the first electrode 20 and the second electrode 11 are prevented from being exposed to the package end surface after dicing and oxidation-corrosion thereof can be prevented beforehand. Further, since the adherence at the interface between the first electrode 20, the second electrode 11 and the ceramic dielectric layer 15 is increased such that interface peeling by the shearing stress at dicing and formation of an intrusion path of intake moisture thereafter can be prevented beforehand. Further, sagging of the first electrode 20 and the second electrode 11 at dicing are never caused, and shortage between layers does not occur. Further, while as compared with the polymer dielectric the conductor (e.g., Cu) constituting the first electrode 20 and the second electrode 11, particularly the strong dielectric (e.g., titanic acid barium) increases the load at dicing and accelerates wear and chipping of a blade, such a problem can be prevented beforehand.

Further, as is apparent from FIG. 1, the wiring board 1 of this invention is formed with a capacitor at the first stacked wiring layer portion 6 only and is not formed with a capacitor at the second stacked wiring layer portion 7. A necessary electrostatic capacity (e.g., 1 *µ* F or more) can be attained by the first stacked wiring layer portion 6, though depending upon the material, etc. of the ceramic dielectric layer 5. If so, a capacitor is not needed at the second stacked wiring layer portion 7. However, with this structure, the number of conductor layers of the second stacked wiring layer portion 7 is smaller than that of the first stacked wiring layer portion 6. Further, the thickness of the second stacked wiring layer portion 7 is smaller than that of the first stacked wiring layer portion 6. As a result, there is caused unbalance of strength between the upper and lower of the core board portion 2 such that it is apprehended that a reliability against bending and peeling is lowered. It is considered to form a surface conductor for power source or grounding at the layer level corresponding to the electrode of the capacitor but such a structure has much waste.

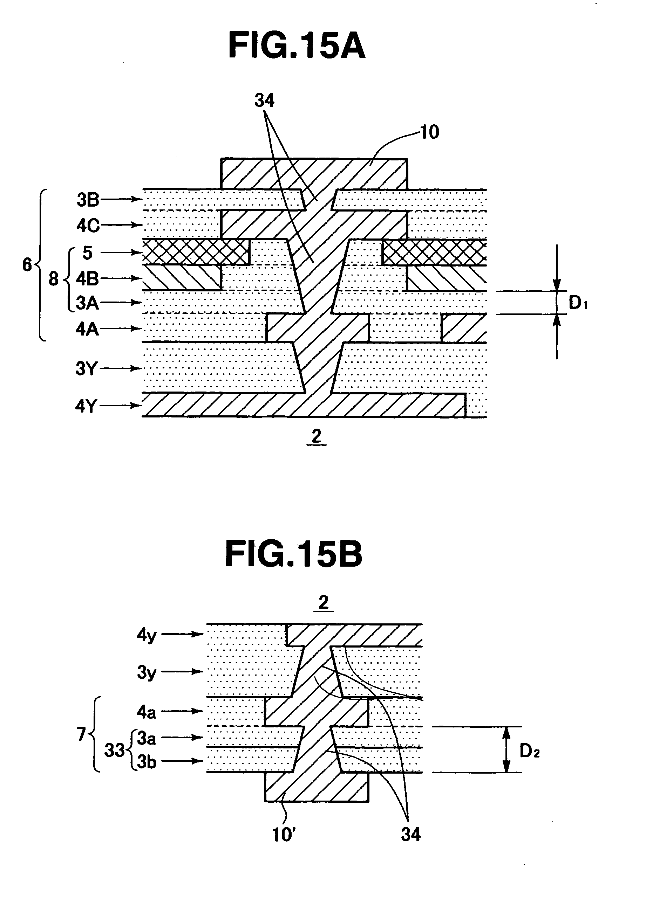

Thus, according to the present invention, as shown in FIGS. 15A and 15B for comparison, the second side stacked wiring layer portion 7 is provided with a polymer dielectric layer 33 that is larger in thickness than the polymer dielectric layer 3A included in the stacked composite layer portion 8, at a corresponding layer level, when counted from the core board portion 2, to the first side stacked composite layer portion 8. Assuming that the thickness of the polymer dielectric layer 3A included in the stacked composite layer portion 8 of the first side stacked wiring layer portion 6 is D1 and the thickness of the polymer dielectric layer 33 of the second side stacked wiring layer portion 7 is D2, a relation of D2≒2D1 is obtained. In the meantime, the thickness of the polymer dielectric layer is basically defined by the thickness of the portion interposed between the conductor layers.

The polymer dielectric layer 33 having the above-described thickness D2 is generally obtained by laminating films twice. Since the polymer dielectric layer uses resin films for build-up process, which are all equal in the thickness and made of the same material irrespective of whether it is on the first side or the second side, a relation of D2≒2D1 is obtained. There is a reason why the polymer dielectric layer 33 is formed by a plurality of independent processes. Hereinafter, detailed description will be made as to the process after the transfer base plate removal step is finished. In the meantime, the process from step 1 of FIG. 4 to step 15 of FIG. 10 (transfer base plate removal step) is for forming the stacked composite layer portion 8 on the core board portion 2 to allow it to serve as a portion of the first side stacked wiring layer portion 6.

After the transfer base plate removal step shown in step 15 of FIG. 10, the process goes to the step of forming the second conductor layer 4C constituting the upper side electrode of the capacitor. In this instance, the process at the second side has advanced to the step of disposing the base conductor layer 4a and the polymer dielectric layer 3a on the core board portion 2. Namely, the process of forming the second side stacked wiring board 7 is stopped at the second stacked layer assembly forming step having been described hereinbefore (step 11 of FIG. 6).

For forming the second conductor layer 4C that constitutes the electrode of the capacitor, a step of drilling the via holes 34h for forming the via conductors 34 for interlayer connection in the stacked composite layer portion 8. This step is for drilling the via holes 34h in the ceramic side polymer filled potion 16 from the main surface side that is exposed by removing the transfer base plate 50, by a laser process or a photolithographic technology as described above. During the step of drilling the vias, the second side polymer dielectric layer 3a is held exposed. Accordingly, in case the photolithographic technology is employed, it is desired to mask the second side polymer dielectric layer 3a with a tape or the like so that the polymer dielectric layer is not etched. Laser LB process does not require such a work such that the number of process steps can be smaller.

As shown in step 16, the via hole 34h is of such a size (diameter) that the polymer filling the conductor side cut portion 18 remains in the in-plane direction between the via hole and the conductor pattern constituting the first conductor layer 4B, while penetrating the ceramic dielectric layer 5, the first conductor layer 4B and the polymer dielectric layer 3A which constitute the stacked composite layer portion 8, in this order from the front surface side so as to expose a conductor constituting the base conductor layer 4A at the bottom. By forming the via hole 34h in a way as to restrict its diameter, the second conductor layer 4C (connected to the base conductor layer 4A by the via conductor 34) can be formed with ease so as to be DC-separated with respect to the first conductor layer 4A. The diameter of the via hole 34h corresponds to a laser LB spot diameter that is adjusted suitably.

Then, the process goes to the step of forming a nonelectrolytic plating layer 91 as shown in step 17 of FIG. 11, but before that step the inside of the via hole 34h is cleaned with chemical fluid (desmear solution) having a corrosion power of corroding polymer. This is because smear (resin smear) due to laser process is formed on the bottom of the via hole 34h. As desmear solution can be used, for example, alkaline potassium permanganate solution. In the meantime, for the step of removing smear at the bottom of the via hole 34h, a wet type using desmear solution can be employed. Further, in consideration of the productivity, a method of immersing a work (wiring board under manufacture) in its entirety into desmear solution is suited.

After the step of removing smear inside the via hole 34h, cleaning steps such as water washing and neutralization are performed, the surface of the work (wiring board under manufacture) is activated and thereafter the process goes to the nonelectrolytic Cu-plating step in step 17. In the nonelectrolytic Cu-plating step, the nonelectrolytic plating layer 91 is formed on the entire surface of the work. Since in the activation step of activating the surface of the work and the nonelectrolytic Cu-plating step, the work is immersed into activation solution and nonelectrolytic Cu-plating solution as it is, a nonelectrolytic Cu-plating layer 91 is also formed on the surface of the polymer dielectric layer 3a but this layer can be removed by quick etching that will be described later, with ease.

The nonelectrolytic Cu-plating layer 91 is a base conductor for conduction of electricity for carrying out the electrolytic Cu-plating step in step 20. The electrolytic Cu-plating step is a step for forming the via conductor 34 inside the via hole 34h and for forming the second conductor layer 4C integrally with the via conductor 34. The electrolytic Cu-plating step is carried out under the condition in which a plating resist layer 92 is formed so that only the portion where a conductor pattern should be formed is exposed. The plating resist 92 is formed, after a dry film resist 92 formed into a film shape is stuck as shown in step 18, by patterning the dry film resist 92 by the lithographic technology as shown in step 19. The plating resist 92 is formed on the second side polymer dielectric layer 3a so as to cover the entire surface thereof. This is for preventing the polymer dielectric layer 3a from contacting electrolytic Cu-plating solution. After the patterning of the plating resist 92 is finished, the electrolytic Cu-plating step in FIG. 12 is carried out, and the second conductor layer 4C is stacked on the ceramic dielectric layer 5 from the side opposite to the first conductor layer 4B. Thus, the capacitor structure constituted by the first conductor layer 4B, the ceramic dielectric layer 5 and the second conductor layer 4C is completed.

In the meantime, while the via conductor 34 is formed so as to be a filled via filling a plating conductor in the entire via hole 34h, a conformal via forming a plating conductor only on the inner wall surface of the via hole 34h can be employed. Further, while in this embodiment a semi-additive method for carrying out an electrolytic Cu-plating step after a base conductor for conduction of electricity is formed by the non-electrolytic Cu-plating step, the second conductor layer 4C having a necessary thickness can be formed by the non-electrolytic plating process only.

After the capacity structure is completed in the manner as described above, the plating resist 92 on the first and second sides is then removed and the non-electrolytic plating layer 92 is removed by quick etching as shown in step 21. Thereafter, by employing the build-up method using a via forming and plating technique, the process is carried out till first side external connection terminals (terminal pads 10) and second side connection terminals (terminal pads 10') are formed. Specifically, the polymer dielectric layer 3B is formed on the first side second dielectric layer 4C, and the second side polymer dielectric layer 3a is covered by a polymer dielectric layer 3b different from the polymer dielectric layer 3a. Since the second side polymer dielectric layer 3a is surface-roughed by the desmear step at the time of formation of the via holes 34h in FIG. 16, it forms a new polymer dielectric layer 33 as described above. By doing so, the polymer dielectric layer 3a and the polymer dielectric layer 3b are joined together and the thick polymer dielectric layer 33 having no roughed surface can be obtained.

It is assumed that the via holes 34h are formed in the second side polymer dielectric layer 3a as shown in step 23 and the terminal pads 10' are formed as shown in step 24. If so, the polymer dielectric layer 3a is processed by the desmear treatment twice such that the surface is roughed excessively. This means that the plating condition is different between the first side and the second side, thus causing a problem that it is difficult to form a plating layer of a uniform thickness and uniform characteristics. In contrast to this, according to the present invention, the polymer dielectric layer 3b is newly formed also on the second side as shown in step 22 of FIG. 12 such that there is never caused any such problem. However, since the first side polymer dielectric layer 3B and the second side polymer dielectric layer 33 are different in thickness, it is necessitated to adjust the condition of laser that is irradiated at the time of formation of via holes, suitably.

Further, by having the thick polymer dielectric layer 33 on the second side, an effect for increasing the strength of the second side stacked wiring layer portion 7 can be expected. Only for the purpose of improving the surface condition, it will suffice to perform a desmear process while protecting the second side polymer dielectric layer 3a, perform a desmear process by spraying desmear solution only upon the first side or perform a dry desmear process so that surface-roughening is not caused. However, this cannot enable to attain an effect of increasing the strength of the second side stacked wiring layer portion 7. Accordingly, it is suitable to employ the procedures of this embodiment. There is, of course, a reason that the method of performing the desmear process while protecting the second side polymer dielectric layer 3a, performing the desmear process by spraying desmear solution only upon the first side or perform the dry desmear process is inferior in the productivity to this embodiment.

Further, it is also possible to make the first side stacked wiring layer portion 6 and the second side stacked wiring layer portion 7 equal in thickness. This makes it possible to prevent bending of the wiring board. In this instance, at the time of formation of the polymer dielectric layer 33, the polymer dielectric layer can be formed by a plurality of times of film-lamination of the polymer dielectric layer 3b. Further, the polymer dielectric layer 33, if it is too thick, causes a problem for good formation of the vias 34 of the second side stacked wiring layer portion 7. Thus, two or a plurality of polymer dielectric layers 33 each comprised only of the polymer dielectric layer 3a and the polymer dielectric layer 3b can be formed while interposing therebetween a conductor layer. In this instance, after a conductor layer of the same pattern as the base conductor layer 4a is formed on the polymer dielectric layer 33, a polymer dielectric layer (can be of the same thickness as the polymer dielectric layer 33) is further formed similarly to the step 22. Thereafter, the polymer dielectric layer is formed with via holes 34 similarly to the step 23 and then vias 34 filling the via holes 34 and terminal pads 10' can be formed by plating.

Further, the first side and second side polymer dielectric layers 3B and 3b can be formed by, other than lamination of polymer formed into a film shape, applying and drying polymer in a liquid state. The former is more suitable. As seen from FIG. 1, the guide through hole 70h used when the stacked composite layer portion 8 is formed on the core board portion 2, remains in the wiring board 1 of the present invention but does not appear to the eye since the opposite ends are closed by the polymer dielectric layers 3B and 3b. In order to form the polymer dielectric layers 3B and 3B so that the guide through holes 70h are closed clean, a method of laminating film-shaped polymer is suitable. It is, of course, more desirable to design the guide through holes 70h so as to be formed in a throwaway portion surrounding a product portion so that the guide through holes do not remain in a final product since there is no need to consider the above-described matters.

## Claims

1. A wiring board **characterized in that** a stacked wiring layer portion in which a dielectric layer and a conductor layer are stacked is formed on at least one main surface of a core board portion, the stacked wiring layer portion includes a stacked composite layer portion in which a polymer dielectric layer, a conductor layer and a ceramic dielectric layer are stacked in this order from a core board portion side so as to contact with each other, the conductor layer in the stacked composite layer portion is partially cut in the in-plane direction so as to have a conductor side cut portion, the ceramic dielectric layer is partially cut in the in-plane direction so as to have a ceramic side cut portion, the ceramic side cut portion and the conductor side cut portion are communicated to form a communication cut portion, and a polymer constituting the polymer dielectric layer is filled in the communication cut portion so as to extend through the conductor side cut portion to the ceramic side cut portion.

2. A wiring board according to claim 1, further comprising, when the conductor layer included in the stacked composite layer portion is referred to as a first conductor layer, a second conductor layer stacked on the ceramic dielectric layer from the side thereof opposite to the first conductor layer, wherein the first conductor layer, the ceramic dielectric layer and the second conductor layer constitute a capacitor.

3. A wiring board according to claim 2, wherein a conductor pattern constituting part of the second conductor layer is disposed so as to contact a ceramic side polymer filled portion filling the ceramic side cut portion of at least one of the communication cut portions, at the side opposite to that at which the ceramic side polymer filled portion communicates the conductor side cut portion, and a boundary surface between the conductor pattern and the ceramic side polymer filled portion is formed flush with a second conductor side main surface of the ceramic dielectric layer.

4. A wiring board according to claim 3, wherein a third conductor layer is formed to contact the polymer dielectric layer at the side thereof opposite to the first conductor layer, and the conductor pattern constituting the second conductor layer and the third conductor layer are conductively connected by a via that penetrates the ceramic dielectric layer, the first conductor layer and the polymer dielectric layer in this order, the first conductor layer and the via are insulated from each other by the polymer filling the conductor side cut portion, and a through hole for forming the via in the ceramic side cut portion is formed in the ceramic side polymer filled portion filling the ceramic side cut portion.

5. A wiring board according to any one of claims 2 to 4, wherein the second conductor layer is formed with, by being partially cut in the in-plane direction, a second conductor side cut portion that communicates part of the communication cut portion, a second conductor side polymer filled portion filling the second conductor side cut portion is joined, at the area communicating the communication cut portion, to the ceramic side polymer filled portion filling the ceramic side cut portion while being partially extended from a periphery of the communication cut portion over the main surface side of the ceramic dielectric layer.

6. A wiring board according to claim 5, wherein the communication cut portion and the second conductor side cut portion are formed along the outer periphery of the ceramic dielectric layer.

7. A wiring board **characterized by** comprising a stacked composite layer portion in which a polymer dielectric layer, a conductor layer and a ceramic dielectric layer made of ceramic of a high dielectric constant are stacked in this order so as to contact with each other, the conductor layer in the stacked composite layer portion being partially cut in the in-plane direction so as to have a conductor side cut portion, the ceramic dielectric layer being partially cut in the in-plane direction so as to have a ceramic side cut portion, the ceramic side cut portion and the conductor side cut portion being communicated to form a communication cut portion, a polymer constituting the polymer dielectric layer being filled in the communication cut portion so as to extend through the conductor side cut portion to the ceramic side cut portion, when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer being withdrawn from an end surface of a unit of the wiring board at least by a first withdrawal width, external end surfaces of the first conductor layer and the second conductor layer being withdrawn from the end surface of the unit of the wiring board at least by a second withdrawal width larger than the first withdrawal width, and a capacitor being constituted by the first conductor layer, the ceramic dielectric layer and the second conductor layer.

8. A wiring board according to claim 7, wherein a conductor pattern constituting part of the second conductor layer is disposed so as to contact a ceramic side polymer filled portion filling the ceramic side cut portion of at least one of the communication cut portions, at the side opposite to that at which the ceramic side polymer filled portion communicates the conductor side cut portion, and a boundary surface between the conductor pattern and the ceramic side polymer filled portion is formed flush with a second conductor side main surface of the ceramic dielectric layer.

9. A wiring board according to claim 8, wherein a third conductor layer that contacts the polymer dielectric layer from the side opposite to the first conductor layer is formed, the conductor pattern constituting the second conductor layer and the third conductor layer are conductively connected by a via conductor that penetrates the ceramic dielectric layer, the first conductor layer and the polymer dielectric layer in this order, the first conductor layer and the via conductor are insulated from each other by the polymer filling the conductor side cut portion, and a through hole for forming the via conductor in the ceramic side cut portion is formed in the ceramic side polymer filled portion filling the ceramic side cut portion.

10. A wiring board according to claim 8 or 9, wherein the second conductor layer is formed with, by being partially cut in the in-plane direction, a second conductor side cut portion that communicates part of the communication cut portion, a second conductor side polymer filled portion filling the second conductor side cut portion is joined, at the area communicating the communication cut portion, to the ceramic side polymer filled portion filling the ceramic side cut portion while being partially extended from a periphery of the communication cut portion over the main surface side of the ceramic dielectric layer.

11. A wiring board according to claim 10, wherein the communication cut portion and the second conductor side cut portion are formed along the outer periphery of the ceramic dielectric layer.

12. A wiring board for mounting thereon an electronic part, **characterized by** comprising a support base having formed therewithin a conductor extending vertically in the thickness direction, the support base being formed at first and second sides with respective stacked wiring layer portions in which a polymer dielectric layer and a conductor layer are stacked, only the first side wiring layer portion positioned on the first side being formed with a capacitor including a ceramic dielectric layer, the first wiring layer portion including a stacked composite layer portion in which a polymer dielectric layer, a conductor layer forming one electrode of the capacitor and a ceramic dielectric layer are stacked in this order from the support base so as to contact with each other, a conductor layer constituting the other electrode of the capacitor being formed so as to cover the ceramic dielectric layer, the second wiring layer portion position on the second side including a polymer dielectric layer that is thicker than the polymer dielectric layer included in the stacked composite layer portion, at a layer level corresponding to the stacked composite layer portion on the first side when counted from the support base.

13. A method of manufacturing a wiring board including a stacked wiring layer portion in which a dielectric layer and a conductor layer are stacked is formed on at least one main surface of a core board portion, the stacked wiring layer portion including a stacked composite layer portion in which a polymer dielectric layer, a conductor layer and a ceramic dielectric layer are stacked in this order from a core board portion side so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly by forming the polymer dielectric layer on one main surface of the core board portion, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

14. A wiring board manufacturing method according to claim 13, wherein in the sticking step, by inserting positioning pins into guide through holes formed in the first stacked layer assembly and the second stacked layer assembly, respectively, the first stacked layer assembly and the second stacked layer assembly are stuck together while being positioned relative to each other.

15. A wiring board manufacturing method according to claim 13 or 14, wherein a metal base plate of a melting point higher than a sintering temperature of ceramic that constitutes the ceramic dielectric layer is used as the transfer base plate, and the first stacked layer assembly manufacturing step includes a non-sintered green ceramic layer forming step of forming a non-sintered green ceramic layer that is made of a non-sintered material of the ceramic dielectric layer and a sintering step of sintering the non-sintered green ceramic layer together with the metal base plate.

16. A wiring board manufacturing method according to claim 15, wherein the non-sintered green ceramic layer is a ceramic green sheet that is formed by mixing ceramic powder with a polymer binding material and forming the ceramic powder mixed with the polymer binding material into a sheet-shape.

17. A wiring board manufacturing method according to claim 16, wherein the ceramic green sheet is stuck onto the metal base plate, then the ceramic green sheet is patterned into the shape of the ceramic dielectric layer to be obtained and thereafter the sintering step is executed.

18. A wiring board manufacturing method according to claim 17, wherein the ceramic green sheet is formed on a carrier sheet made of polymer, the ceramic green sheet in a state of being integrally joined, at the side opposite to the sticking surface, with the carrier sheet, being then stuck onto the metal base plate and laser patterned in this state together with the carrier sheet, thereafter the carrier sheet is removed, and the sintering step is executed.

19. A wiring board manufacturing method according to any one of claims 15 to 18, wherein in the sticking step, the second stacked layer assembly including the core board portion is provided with a plurality of in-plane integrated units of wiring boards to be manufactured, and a plurality of the first stacked layer assemblies each including the units that are smaller in number than those of the second stacked layer assembly are arranged and disposed on the second stacked layer assembly.

20. A wiring board manufacturing method according to claim 19, wherein each of the first stacked layer assemblies are stuck to the second stacked layer assembly while being positioned relative to the second stacked layer assembly by inserting positioning pins into guide through holes formed at respective four corners of the first stacked layer assembly and corresponding guide through holes on the second stacked layer assembly side.

21. A wiring board manufacturing method according to any one of claims 13 to 20, wherein in the transfer base plate removing step, the metal base plate is removed by chemical etching.

22. A wiring board manufacturing method according to any one of claims 13 to 21, wherein the wiring board of any one of claims 1 to 6 is an object to be manufactured, wherein the first stacked layer assembly manufacturing step includes a ceramic side cut portion patterning step of patterning the ceramic side cut portion in the ceramic dielectric layer formed on one main surface of the transfer base plate, a conductor layer forming step of forming the conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

23. A wiring board manufacturing method according to claim 22, wherein a wiring board according to any one of claims 2 to 6 is an object to be manufactured, and wherein after the transfer base plate removing step is finished, the second conductor layer is formed on the main surface side of the ceramic dielectric layer, from which the transfer base plate is removed.

24. A wiring board manufacturing method according to claim 23, wherein a wiring board according to claim 3 or 4 is an object to be manufactured, and wherein in the sticking step, by inserting, under pressure, the polymer into the communication cut portion and curing the polymer, the ceramic side polymer filled portion is formed, by the main surface of the transfer base plate, flush with the ceramic dielectric layer, and thereafter the transfer base plate removing step is executed.

25. A wiring board manufacturing method according to claim 24, wherein a wiring board of claim 4 is an object to be manufactured and wherein the ceramic side polymer filled portion is formed with, from the main surface side exposed by removal of the transfer base plate, a through hole for forming the via, by laser drilling.

26. A wiring board manufacturing method according to claim 23, wherein a wiring board of claim 5 or 6 is an object to be manufactured, and wherein the second conductor layer is formed after the transfer base plate removing step is finished, the second conductor side cut portion is formed so as to communicate part of the communication cut portion, another polymer dielectric layer is formed and stacked on the main surface of the second conductor layer which is formed with the second conductor side cut portion, and the polymer constituting the polymer dielectric layer is filled into the second conductor side cut portion to join the polymer dielectric layer and the ceramic side polymer filled portion together.

27. A method of manufacturing a wiring board including a stacked composite layer portion in which a polymer dielectric layer, a conductor layer and a ceramic dielectric layer made of ceramic of a high dielectric constant are stacked in this order so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly formed with the polymer dielectric layer, a sticking step of sticking the conductor layer of the first stacked layer assembly and the polymer dielectric layer of the second stacked layer assembly so that when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer is withdrawn from an end surface of a unit of the wiring board at least by a first withdrawal width, external end surfaces of the first conductor layer and the second conductor layer are withdrawn from the end surface of the unit of the wiring board at least by a second withdrawal width larger than the first withdrawal width, and a capacitor is constituted by the first conductor layer, the ceramic dielectric layer and the second conductor layer, and a transfer base plate removing step of removing the transfer base plate from the ceramic dielectric layer, in this order.

28. A wiring board manufacturing method according to claim 27, wherein in the sticking step, the second stacked layer assembly including the core board portion is provided with a plurality of in-plane integrated units of wiring boards to be manufactured, and a plurality of first stacked layer assemblies each including the units that are smaller in number than those of the second stacked layer assembly are arranged and disposed on the second stacked layer assembly.

29. A wiring board manufacturing method according to claim 27 or 28, wherein in the sticking step, by inserting positioning pins into guide through holes formed in the first stacked layer assembly and the second stacked layer assembly, respectively, a plurality of the first stacked layer assemblies and the second stacked layer assembly are stuck together while being positioned relative to each other.

30. A wiring board manufacturing method according to claim 29, wherein by inserting the positioning pins into the guide through holes formed in the first stacked layer assembly and the corresponding through holes of the second stacked layer assembly, the first stacked layer assembly is stuck to the second stacked layer assembly while being positioned relative thereto.

31. A wiring board manufacturing method according to any one of claims 27 to 30, wherein in the sticking step, a plurality of the first stacked layer assemblies are disposed in accommodation portions formed in a spacer, and the conductor layers of the plurality of the first stacked layer assemblies and the polymer dielectric layer of the second stacked layer assembly are stuck to each other.

32. A wiring board manufacturing method according to claim 31, wherein the spacer is made from a metal plate of the same thickness as the plurality of the first stacked layer assemblies.

33. A wiring board manufacturing method according to any one of claims 27 to 31, wherein the first stacked layer assembly manufacturing step includes a ceramic side cut portion patterning step of patterning the ceramic side cut portion in the ceramic dielectric layer formed on one main surface of the transfer base plate, a conductor layer forming step of forming the conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in a state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

34. A wiring board manufacturing method according to claim 33, wherein in the sticking step, by inserting, under pressure, the polymer into the communication cut portion and curing the polymer, the ceramic side polymer filled portion is formed, by the main surface of the transfer base plate, flush with the ceramic dielectric layer, and thereafter the transfer base plate removing step is executed.

35. A method of manufacturing a wiring board including a stacked composite layer portion in which a polymer dielectric layer, a conductor layer and a ceramic dielectric layer made of ceramic of a high dielectric constant are stacked in this order so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing, separately of the first stacked layer assembly, a second stacked layer assembly having at a sticking surface side the polymer dielectric layer, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

36. A wiring board manufacturing method according to claim 35, wherein in the sticking step, by inserting positioning pins into guide through holes formed in the first stacked layer assembly and the second stacked layer assembly, respectively, a plurality of the first stacked layer assemblies and the second stacked layer assembly are stuck together while being positioned relative to each other.

37. A wiring board manufacturing method according to claim 35 or 36, wherein a metal base plate of a melting point higher than a sintering temperature of ceramic that constitutes the ceramic dielectric layer is used as the transfer base plate, and the first stacked layer assembly manufacturing step includes a non-sintered green ceramic layer forming step of forming a non-sintered green ceramic layer that is made of a non-sintered material of the ceramic dielectric layer and a sintering step of sintering the non-sintered green ceramic layer together with the metal base plate.

38. A wiring board manufacturing method according to claim 37, wherein by inserting positioning pins into guide through holes formed in the first stacked layer assembly and the second stacked layer assembly, respectively, a plurality of the first stacked layer assemblies and the second stacked layer assembly are stuck together while being positioned relative to each other, and the guide through holes are formed in the metal base plate by chemical etching.

39. A wiring board manufacturing method according to claim 37 or 38, wherein the non-sintered green ceramic layer is a ceramic green sheet that is formed by mixing ceramic powder with a polymer binding material and forming the ceramic powder mixed with the polymer binding material into a sheet-shape.

40. A wiring board manufacturing method according to claim 39, wherein the ceramic green sheet is stuck onto the metal base plate, then the ceramic green sheet is patterned into the shape of the ceramic dielectric layer to be obtained and thereafter the sintering step is executed.

41. A wiring board manufacturing method according to claim 40, wherein the ceramic green sheet is formed on a carrier sheet made of polymer, the ceramic green sheet in a state of being integrally joined, at the side opposite to the sticking surface, with the carrier sheet, is then stuck onto the metal base plate and laser patterned in this state together with the carrier sheet, thereafter the carrier sheet is removed, and the sintering step is executed.

42. A wiring board manufacturing method according to claim 41, wherein the thickness of the ceramic green sheet is adjusted so that the thickness of the ceramic dielectric layer obtained by sintering is in the range from 1 *µ*m to 100 *µ*m.

43. A wiring board manufacturing method according to claim 42, wherein a polyethylene terephthalate resin sheet of the thickness in the range from 20 *µ*m to 100 *µm* is used as the carrier sheet.

44. A wiring board manufacturing method according to any one of claims 35 to 43, wherein in the transfer base plate removing step, the metal base plate is removed by chemical etching.

45. A wiring board manufacturing method according to any one of claims 35 to 44, wherein in the sticking step, the first stacked layer assembly and the second stacked layer assembly are stuck together by being pressurized in the stacking direction.

46. A method of manufacturing a capacitor built-in type wiring board having a support base having formed therewithin a conductor extending vertically in the thickness direction, the support base being formed at first and second sides with respective stacked wiring layer portions in which a polymer dielectric layer and a conductor layer are stacked, only a first side stacked wiring layer portion positioned on the first side being formed with a capacitor including a ceramic dielectric layer, **characterized by** comprising a step of forming a stacked composite layer portion in which a polymer dielectric layer, a conductor layer serving as one electrode of the capacitor and a ceramic dielectric layer are stacked in this order from the support base side so as to contact with each other, in such a manner that the stacked composite layer portion constitutes part of the first side stacked wiring layer portion and is formed on the support base, a step of forming on the support base or in a way as to be included in the support base a polymer dielectric layer for constituting a second side stacked wiring layer portion positioned on the second side, a step of making a via hole for forming a via conductor for interlayer connection in the first side stacked composite layer portion under the condition where the polymer dielectric layer is exposed to the second side, a step of cleaning the inside of the via hole formed on the first side under the condition where the polymer dielectric layer is exposed to the second side, with chemical fluid having a corrosion power of corroding polymer, a step of forming on an inner surface of the via hole a conductor and thereby constituting the via conductor, stacking, when the conductor layer included in the stacked composite layer portion is referred to as a first conductor layer, a second conductor layer on the ceramic dielectric layer from the side opposite to the first conductor layer and thereby constituting the capacitor by the first conductor layer, the ceramic dielectric layer and the second conductor layer, and a step of covering the second side polymer dielectric layer that is surface-roughened with chemicals, with another polymer dielectric layer and joining the new and old polymer dielectric layers together.

47. A wiring board manufacturing method according to claim 46, wherein the step of covering the polymer dielectric layer with another polymer dielectric layer is a step of laminating a polymer film or a step of applying polymer in a liquid state.

48. A wiring board manufacturing method according to claim 46 or 47, wherein formation of the first side stacked wiring layer portion and the second side stacked wiring layer portion is proceeded by a build-up process in which the step of covering the second side polymer dielectric layer with another dielectric layer and the step of forming a new dielectric layer on the first side, are executed at the same period of time and other conductor layers are formed by a via forming step and a pattern plating step.

49. A wiring board manufacturing method according to any one of claims 46 to 48, wherein the step of forming the stacked composite layer is a step of executing a first stacked layer assembly manufacturing step of manufacturing a first stacked layer assembly by forming a ceramic dielectric layer and a conductor layer in this order on one main surface of a transfer base plate, a second stacked layer assembly manufacturing step of manufacturing a second stacked layer assembly by forming a polymer dielectric layer on a main surface of the support base, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

50. A wiring board manufacturing method according to claim 49, wherein the first stacked layer assembly manufacturing step comprises a ceramic side cut portion patterning step of patterning the ceramic side cut portion in the ceramic dielectric layer formed on one main surface of the transfer base plate, a conductor layer forming step of forming a conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

51. A wiring board manufacturing method according to claim 50, wherein by inserting, under pressure, the polymer into the communication cut portion and curing the polymer, the ceramic side polymer filled portion is formed, by the main surface of the transfer base plate, flush with the ceramic dielectric layer, thereafter the transfer base plate removing step is executed, and the ceramic side polymer filled portion is formed with, from the main surface side exposed by removal of the transfer base plate, a through hole for forming the via, by a laser process.

52. A wiring board manufacturing method according to claim 51, wherein the step of making the via hole is a step of forming the via hole so that the via hole is of such a size that the polymer filling the conductor side cut portion remains between the via hole and the first conductor layer while penetrating the ceramic dielectric layer, the first conductor layer and the polymer dielectric layer, in this order.

## Amended claims

### Amended claims under Art. 19.1 PCT

**1.** A wiring board **characterized in that** a stacked wiring layer portion in which a dielectric layer and a conductor layer are stacked is formed on at least one main surface of a core board portion, the stacked wiring layer portion includes a stacked composite layer portion in which a polymer dielectric layer, a conductor layer and a ceramic dielectric layer are stacked in this order from a core board portion side so as to contact with each other, the conductor layer in the stacked composite layer portion is partially cut in the in-plane direction so as to have a conductor side cut portion, the ceramic dielectric layer is partially cut in the in-plane direction so as to have a ceramic side cut portion, the ceramic side cut portion and the conductor side cut portion are communicated to form a communication cut portion, and a polymer constituting the polymer dielectric layer is filled in the communication cut portion so as to extend through the conductor side cut portion to the ceramic side cut portion.

**2.** A wiring board according to claim 1, further comprising, when the conductor layer included in the stacked composite layer portion is referred to as a first conductor layer, a second conductor layer stacked on the ceramic dielectric layer from the side thereof opposite to the first conductor layer, wherein the first conductor layer, the ceramic dielectric layer and the second conductor layer constitute a capacitor.

**3.** A wiring board according to claim 2, wherein a conductor pattern constituting part of the second conductor layer is disposed so as to contact a ceramic side polymer filled portion filling the ceramic side cut portion of at least one of the communication cut portions, at the side opposite to that at which the ceramic side polymer filled portion communicates the conductor side cut portion, and a boundary surface between the conductor pattern and the ceramic side polymer filled portion is formed flush with a second conductor side main surface of the ceramic dielectric layer.

**4.** A wiring board according to claim 3, wherein a third conductor layer is formed to contact the polymer dielectric layer at the side thereof opposite to the first conductor layer, and the conductor pattern constituting the second conductor layer and the third conductor layer are conductively connected by a via that penetrates the ceramic dielectric layer, the first conductor layer and the polymer dielectric layer in this order, the first conductor layer and the via are insulated from each other by the polymer filling the conductor side cut portion, and a through hole for forming the via in the ceramic side cut portion is formed in the ceramic side polymer filled portion filling the ceramic side cut portion.

**5.** A wiring board according to any one of claims 2 to 4, wherein the second conductor layer is formed with, by being partially cut in the in-plane direction, a second conductor side cut portion that communicates part of the communication cut portion, a second conductor side polymer filled portion filling the second conductor side cut portion is joined, at the area communicating the communication cut portion, to the ceramic side polymer filled portion filling the ceramic side cut portion while being partially extended from a periphery of the communication cut portion over the main surface side of the ceramic dielectric layer.

**6.** A wiring board according to claim 5, wherein the communication cut portion and the second conductor side cut portion are formed along the outer periphery of the ceramic dielectric layer.

**7.** (After amendment) A wiring board **characterized by** comprising a stacked composite layer portion in which a polymer dielectric layer, a conductor layer and a ceramic dielectric layer made of ceramic of a high dielectric constant are stacked in this order so as to contact with each other, the conductor layer in the stacked composite layer portion being partially cut inward of a surface thereof so as to have a conductor side cut portion, the ceramic dielectric layer being partially cut inward of a surface thereof so as to have a ceramic side cut portion, the ceramic side cut portion and the conductor side cut portion being communicated to form a communication cut portion, a polymer constituting the polymer dielectric layer being filled in the communication cut portion so as to extend through the conductor side cut portion to the ceramic side cut portion, when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer being withdrawn from an end surface of a unit of the wiring board at least by a first withdrawal width and external end surfaces of the first conductor layer and the second conductor layer being withdrawn from the end surface of the unit of the wiring board at least by a second withdrawal width larger than the first withdrawal width, a capacitor being constituted by the first conductor layer, the ceramic dielectric layer and the second conductor layer, the second conductor layer being formed with, by being partially cut in the in-plane direction, a second conductor side cut portion that communicates part of the communication cut portion, and a second conductor side polymer filled portion filling the second conductor side cut portion being joined, at the area communicating the communication cut portion, to the ceramic side polymer filled portion filling the ceramic side cut portion while being partially extended from a periphery of the communication cut portion over the main surface side of the ceramic dielectric layer.

**8.** A wiring board according to claim 7, wherein a conductor pattern constituting part of the second conductor layer is disposed so as to contact a ceramic side polymer filled portion filling the ceramic side cut portion of at least one of the communication cut portions, at the side opposite to that at which the ceramic side polymer filled portion communicates the conductor side cut portion, and a boundary surface between the conductor pattern and the ceramic side polymer filled portion is formed flush with a second conductor side main surface of the ceramic dielectric layer.

**9.** A wiring board according to claim 8, wherein a third conductor layer that contacts the polymer dielectric layer from the side opposite to the first conductor layer is formed, the conductor pattern constituting the second conductor layer and the third conductor layer are conductively connected by a via conductor that penetrates the ceramic dielectric layer, the first conductor layer and the polymer dielectric layer in this order, the first conductor layer and the via conductor are insulated from each other by the polymer filling the conductor side cut portion, and a through hole for forming the via conductor in the ceramic side cut portion 16 is formed in the ceramic side polymer filled portion filling the ceramic side cut portion.

**10.** (After amendment) A wiring board according to any one of claims 7 to 9, wherein the second withdrawal width is in the range from 0.8 mm to 2.5 mm.

**11.** A wiring board according to claim 10, wherein the communication cut portion and the second conductor side cut portion are formed along the outer periphery of the ceramic dielectric layer.

**12.** A wiring board for mounting thereon an electronic part, **characterized by** comprising a support base having formed therewithin a conductor extending vertically in the thickness direction, the support base being formed at first and second sides with respective stacked wiring layer portions in which a polymer dielectric layer and a conductor layer are stacked, only the first side wiring layer portion positioned on the first side being formed with a capacitor including a ceramic dielectric layer, the first wiring layer portion including a stacked composite layer portion in which a polymer dielectric layer, a conductor layer forming one electrode of the capacitor and a ceramic dielectric layer are stacked in this order from the support base so as to contact with each other, a conductor layer constituting the other electrode of the capacitor being formed so as to cover the ceramic dielectric layer, the second wiring layer portion position on the second side including a polymer dielectric layer that is thicker than the polymer dielectric layer included in the stacked composite layer portion, at a layer level corresponding to the stacked composite layer portion on the first side when counted from the support base.

**13.** A method of manufacturing a wiring board including a stacked wiring layer portion in which a dielectric layer and a conductor layer are stacked is formed on at least one main surface of a core board portion, the stacked wiring layer portion including a stacked composite layer portion in which a polymer dielectric layer, a conductor layer and a ceramic dielectric layer are stacked in this order from a core board portion side so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly by forming the polymer dielectric layer on one main surface of the core board portion, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

**14.** A wiring board manufacturing method according to claim 13, wherein in the sticking step, by inserting positioning pins into guide through holes formed in the first stacked layer assembly and the second stacked layer assembly, respectively, the first stacked layer assembly and the second stacked layer assembly are stuck together while being positioned relative to each other.

**15.** A wiring board manufacturing method according to claim 13 or 14, wherein a metal base plate of a melting point higher than a sintering temperature of ceramic that constitutes the ceramic dielectric layer is used as the transfer base plate, and the first stacked layer assembly manufacturing step includes a non-sintered green ceramic layer forming step of forming a non-sintered green ceramic layer that is made of a non-sintered material of the ceramic dielectric layer and a sintering step of sintering the non-sintered green ceramic layer together with the metal base plate.

**16.** A wiring board manufacturing method according to claim 15, wherein the non-sintered green ceramic layer is a ceramic green sheet that is formed by mixing ceramic powder with a polymer binding material and forming the ceramic powder mixed with the polymer binding material into a sheet-shape.

**17.** A wiring board manufacturing method according to claim 16, wherein the ceramic green sheet is stuck onto the metal base plate, then the ceramic green sheet is patterned into the shape of the ceramic dielectric layer to be obtained and thereafter the sintering step is executed.

**18.** A wiring board manufacturing method according to claim 17, wherein the ceramic green sheet is formed on a carrier sheet made of polymer, the ceramic green sheet in a state of being integrally joined, at the side opposite to the sticking surface, with the carrier sheet, being then stuck onto the metal base plate and laser patterned in this state together with the carrier sheet, thereafter the carrier sheet is removed, and the sintering step is executed.

**19.** A wiring board manufacturing method according to any one of claims 15 to 18, wherein in the sticking step, the second stacked layer assembly including the core board portion is provided with a plurality of in-plane integrated units of wiring boards to be manufactured, and a plurality of the first stacked layer assemblies each including the units that are smaller in number than those of the second stacked layer assembly are arranged and disposed on the second stacked layer assembly.

**20.** A wiring board manufacturing method according to claim 19, wherein each of the first stacked layer assemblies are stuck to the second stacked layer assembly while being positioned relative to the second stacked layer assembly by inserting positioning pins into guide through holes formed at respective four corners of the first stacked layer assembly and corresponding guide through holes on the second stacked layer assembly side.

**21.** A wiring board manufacturing method according to any one of claims 13 to 20, wherein in the transfer base plate removing step, the metal base plate is removed by chemical etching.

**22.** A wiring board manufacturing method according to any one of claims 13 to 21, wherein the wiring board of any one of claims 1 to 6 is an object to be manufactured, wherein the first stacked layer assembly manufacturing step includes a ceramic side cut portion patterning step of patterning the ceramic side cut portion in the ceramic dielectric layer formed on one main surface of the transfer base plate, a conductor layer forming step of forming the conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

**23.** A wiring board manufacturing method according to claim 22, wherein a wiring board according to any one of claims 2 to 6 is an object to be manufactured, and wherein after the transfer base plate removing step is finished, the second conductor layer is formed on the main surface side of the ceramic dielectric layer, from which the transfer base plate is removed.

**24.** A wiring board manufacturing method according to claim 23, wherein a wiring board according to claim 3 or 4 is an object to be manufactured, and wherein in the sticking step, by inserting, under pressure, the polymer into the communication cut portion and curing the polymer, the ceramic side polymer filled portion is formed, by the main surface of the transfer base plate, flush with the ceramic dielectric layer, and thereafter the transfer base plate removing step is executed.

**25.** A wiring board manufacturing method according to claim 24, wherein a wiring board of claim 4 is an object to be manufactured and wherein the ceramic side polymer filled portion is formed with, from the main surface side exposed by removal of the transfer base plate, a through hole for forming the via, by laser drilling.

**26.** A wiring board manufacturing method according to claim 23, wherein a wiring board of claim 5 or 6 is an object to be manufactured, and wherein the second conductor layer is formed after the transfer base plate removing step is finished, the second conductor side cut portion is formed so as to communicate part of the communication cut portion, another polymer dielectric layer is formed and stacked on the main surface of the second conductor layer which is formed with the second conductor side cut portion, and the polymer constituting the polymer dielectric layer is filled into the second conductor side cut portion to join the polymer dielectric layer and the ceramic side polymer filled portion together.

**27.** A method of manufacturing a wiring board including a stacked composite layer portion in which a polymer dielectric layer, a conductor layer and a ceramic dielectric layer made of ceramic of a high dielectric constant are stacked in this order so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing a second stacked layer assembly formed with the polymer dielectric layer, a sticking step of sticking the conductor layer of the first stacked layer assembly and the polymer dielectric layer of the second stacked layer assembly so that when the conductor layer included in the stacked composite layer is referred to as a first conductor layer and a conductor layer stacked on the ceramic dielectric layer from the side opposite to the first conductor layer is referred to as a second conductor layer, an external end surface of the ceramic dielectric layer is withdrawn from an end surface of a unit of the wiring board at least by a first withdrawal width, external end surfaces of the first conductor layer and the second conductor layer are withdrawn from the end surface of the unit of the wiring board at least by a second withdrawal width larger than the first withdrawal width, and a capacitor is constituted by the first conductor layer, the ceramic dielectric layer and the second conductor layer, and a transfer base plate removing step of removing the transfer base plate from the ceramic dielectric layer.

**28.** A wiring board manufacturing method according to claim 27, wherein in the sticking step, the second stacked layer assembly including the core board portion is provided with a plurality of in-plane integrated units of wiring boards to be manufactured, and a plurality of first stacked layer assemblies each including the units that are smaller in number than those of the second stacked layer assembly are arranged and disposed on the second stacked layer assembly.

**29.** A wiring board manufacturing method according to claim 27 or 28, wherein in the sticking step, by inserting positioning pins into guide through holes formed in the first stacked layer assembly and the second stacked layer assembly, respectively, a plurality of the first stacked layer assemblies and the second stacked layer assembly are stuck together while being positioned relative to each other.

**30.** A wiring board manufacturing method according to claim 29, wherein by inserting the positioning pins into the guide through holes formed in the first stacked layer assembly and the corresponding through holes of the second stacked layer assembly, the first stacked layer assembly is stuck to the second stacked layer assembly while being positioned relative thereto.

**31.** A wiring board manufacturing method according to any one of claims 27 to 30, wherein in the sticking step, a plurality of the first stacked layer assemblies are disposed in accommodation portions formed in a spacer, and the conductor layers of the plurality of the first stacked layer assemblies and the polymer dielectric layer of the second stacked layer assembly are stuck to each other.

**32.** A wiring board manufacturing method according to claim 31, wherein the spacer is made from a metal plate of the same thickness as the plurality of the first stacked layer assemblies.

**33.** A wiring board manufacturing method according to any one of claims 27 to 31, wherein the first stacked layer assembly manufacturing step includes a ceramic side cut portion patterning step of patterning the ceramic side cut portion in the ceramic dielectric layer formed on one main surface of the transfer base plate, a conductor layer forming step of forming the conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in a state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

**34.** A wiring board manufacturing method according to claim 33, wherein in the sticking step, by inserting, under pressure, the polymer into the communication cut portion and curing the polymer, the ceramic side polymer filled portion is formed, by the main surface of the transfer base plate, flush with the ceramic dielectric layer, and thereafter the transfer base plate removing step is executed.

**35.** A method of manufacturing a wiring board including a stacked composite layer portion in which a polymer dielectric layer, a conductor layer and a ceramic dielectric layer made of ceramic of a high dielectric constant are stacked in this order so as to contact with each other, **characterized by** executing a first stacked layer assembly manufacturing step of manufacturing a first stacked layer assembly by forming the ceramic dielectric layer and the conductor layer in this order on one main surface of a transfer base plate, a second stacked layer assembly manufacturing step of manufacturing, separately of the first stacked layer assembly, a second stacked layer assembly having at a sticking surface side the polymer dielectric layer, a sticking step of sticking the conductor layer of the first stacked layer assembly and the polymer dielectric layer of the second stacked layer assembly together, and a transfer base plate removing step of removing the transfer base plate from the ceramic dielectric layer.

**36.** A wiring board manufacturing method according to claim 35, wherein in the sticking step, by inserting positioning pins into guide through holes formed in the first stacked layer assembly and the second stacked layer assembly, respectively, a plurality of the first stacked layer assemblies and the second stacked layer assembly are stuck together while being positioned relative to each other.

**37.** A wiring board manufacturing method according to claim 35 or 36, wherein a metal base plate of a melting point higher than a sintering temperature of ceramic that constitutes the ceramic dielectric layer is used as the transfer base plate, and the first stacked layer assembly manufacturing step includes a non-sintered green ceramic layer forming step of forming a non-sintered green ceramic layer that is made of a non-sintered material of the ceramic dielectric layer and a sintering step of sintering the non-sintered green ceramic layer together with the metal base plate.

**38.** A wiring board manufacturing method according to claim 37, wherein by inserting positioning pins into guide through holes formed in the first stacked layer assembly and the second stacked layer assembly, respectively, a plurality of the first stacked layer assemblies and the second stacked layer assembly are stuck together while being positioned relative to each other, and the guide through holes are formed in the metal base plate by chemical etching.

**39.** A wiring board manufacturing method according to claim 37 or 38, wherein the non-sintered green ceramic layer is a ceramic green sheet that is formed by mixing ceramic powder with a polymer binding material and forming the ceramic powder mixed with the polymer binding material into a sheet-shape.

**40.** A wiring board manufacturing method according to claim 39, wherein the ceramic green sheet is stuck onto the metal base plate, then the ceramic green sheet is patterned into the shape of the ceramic dielectric layer to be obtained and thereafter the sintering step is executed.

**41.** A wiring board manufacturing method according to claim 40, wherein the ceramic green sheet is formed on a carrier sheet made of polymer, the ceramic green sheet in a state of being integrally joined, at the side opposite to the sticking surface, with the carrier sheet, is then stuck onto the metal base plate and laser patterned in this state together with the carrier sheet, thereafter the carrier sheet is removed, and the sintering step is executed.

**42.** A wiring board manufacturing method according to claim 41, wherein the thickness of the ceramic green sheet is adjusted so that the thickness of the ceramic dielectric layer obtained by sintering is in the range from 1 *µ*m to 100 *µ*m.

**43.** A wiring board manufacturing method according to claim 42, wherein a polyethylene terephthalate resin sheet of the thickness in the range from 20 *µ* m to 100 *µ* m is used as the carrier sheet.

**44.** A wiring board manufacturing method according to any one of claims 35 to 43, wherein in the transfer base plate removing step, the metal base plate is removed by chemical etching.

**45.** A wiring board manufacturing method according to any one of claims 35 to 44, wherein in the sticking step, the first stacked layer assembly and the second stacked layer assembly are stuck together by being pressurized in the stacking direction.

**46.** A method of manufacturing a capacitor built-in type wiring board having a support base having formed therewithin a conductor extending vertically in the thickness direction, the support base being formed at first and second sides with respective stacked wiring layer portions in which a polymer dielectric layer and a conductor layer are stacked, only a first side stacked wiring layer portion positioned on the first side being formed with a capacitor including a ceramic dielectric layer, **characterized by** comprising a step of forming a stacked composite layer portion in which a polymer dielectric layer, a conductor layer serving as one electrode of the capacitor and a ceramic dielectric layer are stacked in this order from the support base side so as to contact with each other, in such a manner that the stacked composite layer portion constitutes part of the first side stacked wiring layer portion and is formed on the support base, a step of forming on the support base or in a way as to be included in the support base a polymer dielectric layer for constituting a second side stacked wiring layer portion positioned on the second side, a step of making a via hole for forming a via conductor for interlayer connection in the first side stacked composite layer portion under the condition where the polymer dielectric layer is exposed to the second side, a step of cleaning the inside of the via hole formed on the first side under the condition where the polymer dielectric layer is exposed to the second side, with chemical fluid having a corrosion power of corroding polymer, a step of forming on an inner surface of the via hole a conductor and thereby constituting the via conductor, stacking, when the conductor layer included in the stacked composite layer portion is referred to as a first conductor layer, a second conductor layer on the ceramic dielectric layer from the side opposite to the first conductor layer and thereby constituting the capacitor by the first conductor layer, the ceramic dielectric layer and the second conductor layer, and a step of covering the second side polymer dielectric layer that is surface-roughened with chemicals, with another polymer dielectric layer and joining the new and old polymer dielectric layers together.

**47.** A wiring board manufacturing method according to claim 46, wherein the step of covering the polymer dielectric layer with another polymer dielectric layer is a step of laminating a polymer film or a step of applying polymer in a liquid state.

**48.** A wiring board manufacturing method according to claim 46 or 47, wherein formation of the first side stacked wiring layer portion and the second side stacked wiring layer portion is proceeded by a build-up process in which the step of covering the second side polymer dielectric layer with another dielectric layer and the step of forming a new dielectric layer on the first side, are executed at the same period of time and other conductor layers are formed by a via forming step and a pattern plating step.

**49.** A wiring board manufacturing method according to any one of claims 46 to 48, wherein the step of forming the stacked composite layer is a step of executing a first stacked layer assembly manufacturing step of manufacturing a first stacked layer assembly by forming a ceramic dielectric layer and a conductor layer in this order on one main surface of a transfer base plate, a second stacked layer assembly manufacturing step of manufacturing a second stacked layer assembly by forming a polymer dielectric layer on a main surface of the support base, a sticking step of sticking the conductor layer of the first stacked layer assembly and the polymer dielectric layer of the second stacked layer assembly together, and a transfer base plate removing step of removing the transfer base plate from the ceramic dielectric layer, in this order.

**50.** A wiring board manufacturing method according to claim 49, wherein the first stacked layer assembly manufacturing step comprises a ceramic side cut portion patterning step of patterning the ceramic side cut portion in the ceramic dielectric layer formed on one main surface of the transfer base plate, a conductor layer forming step of forming a conductor layer on the ceramic dielectric layer after the patterning, and a conductor side cut portion patterning step of patterning the conductor side cut portion in the conductor layer in a way as to communicate the conductor side cut portion with the ceramic side cut portion, and wherein in the sticking step, on the first stacked layer assembly which is formed with the communication cut portions including the ceramic side cut portion and the conductor side cut portion communicated therewith is stacked the second stacked layer assembly in the state in which the polymer dielectric layer is uncured or semi-cured in a way as to stack the main surface of the polymer dielectric layer on an open side main surface of the communication cut portion, under this condition the first stacked layer assembly and the second stacked layer assembly are pressurized in the stacking direction to cause the uncured or semi-cured polymer constituting the polymer dielectric layer to be filled in the communication cut portion under pressure and thereafter the polymer is cured.

**51.** A wiring board manufacturing method according to claim 50, wherein by inserting, under pressure, the polymer into the communication cut portion and curing the polymer, the ceramic side polymer filled portion is formed, by the main surface of the transfer base plate, flush with the ceramic dielectric layer, thereafter the transfer base plate removing step is executed, and the ceramic side polymer filled portion is formed with, from the main surface side exposed by removal of the transfer base plate, a through hole for forming the via, by a laser process.

**52.** A wiring board manufacturing method according to claim 51, wherein the step of making the via hole is a step of forming the via hole so that the via hole is of such a size that the polymer filling the conductor side cut portion remains between the via hole and the first conductor layer while penetrating the ceramic dielectric layer, the first conductor layer and the polymer dielectric layer, in this order.
